# EUROPEAN PATENT APPLICATION

(11) **EP 0 852 401 A2**
(43) Date of publication of application: **08.07.1998**
(21) Application number: 98100078.9
(22) Date of filing: 05.01.1998
(51) Int. Cl.: H01L 27/088, H01L 27/02, H01L 21/8234

(54) **Semiconductor device and method of manufacturing the same**

(30) Priority: 07.01.1997 JP 508/97; 16.09.1997 JP 250422/97
(71) Applicant: MATSUSHITA ELECTRIC INDUSTRIAL CO., LTD., Kadoma-shi, Osaka 571 (JP)
(72) Inventor: Hiroki, Akira, Izumi-shi, Osaka 590-02 (JP); Odanaka, Shinji, Hirakata-shi, Osaka 573 (JP)
(74) Representative: Grünecker, Kinkeldey, Stockmair & Schwanhäusser Anwaltssozietät

(57) **Abstract**

A semiconductor substrate made of P-type silicon is formed with two MOS transistors having a first gate electrode and a second gate electrode placed in parallel with each other. A first N-type impurity drain diffusion layer and a second N-type impurity source diffusion layer are connected in series between the first and second gate electrodes. A first high-concentration P-type impurity diffusion layer for threshold control is formed in a source-side portion of a channel region of the semiconductor substrate underlying a portion of the first gate electrode closer to the first N-type impurity source diffusion layer, while a second high-concentration P-type impurity diffusion layer for threshold control is formed under a portion of the second gate electrode closer to the second N-type impurity source diffusion layer.

## Description

### BACKGROUND OF THE INVENTION

The present invention relates to semiconductor devices comprising MIS transistors and, more particularly, to a lower-power semiconductor device operating at a higher speed with excellent reliability, in which a miniaturized CMOS logic circuit or DRAM circuit is provided.

To implement a VLSI higher in integration, a MOS semiconductor device used in the VLSI has been increasingly miniaturized to have a minimum feature size on the halfmicron or subhalfmicron order. On the laboratory level, even a semiconductor device having a quartermicron or subquartermicron feature size has been produced experimentally. However, the increasing miniaturization of a semiconductor device has presented a serious problem associated with the reliability thereof, which is the degradation of the electric properties of the semiconductor device caused by a short-channel effect and a hot-carrier effect.

Besides higher integration, VLSI technology is also expected to implement a semiconductor device achieving a higher operating speed and lower power consumption even during operation at a low voltage, which are important factors in realizing a future multimedia society.

For the accomplishment of improved resistance to the hot-carrier degradation and to the short-channel effect, there has recently been proposed a MOS semiconductor device as a power element having a channel in which an impurity has been distributed asymmetrically. For example, an LDC structure has been proposed by T. Matsuki et al. (see 1991 Symposium on VLSI Technology, pp. 113-114).

Referring to the drawings, a conventional MOS semiconductor device with the LDC structure will be described.

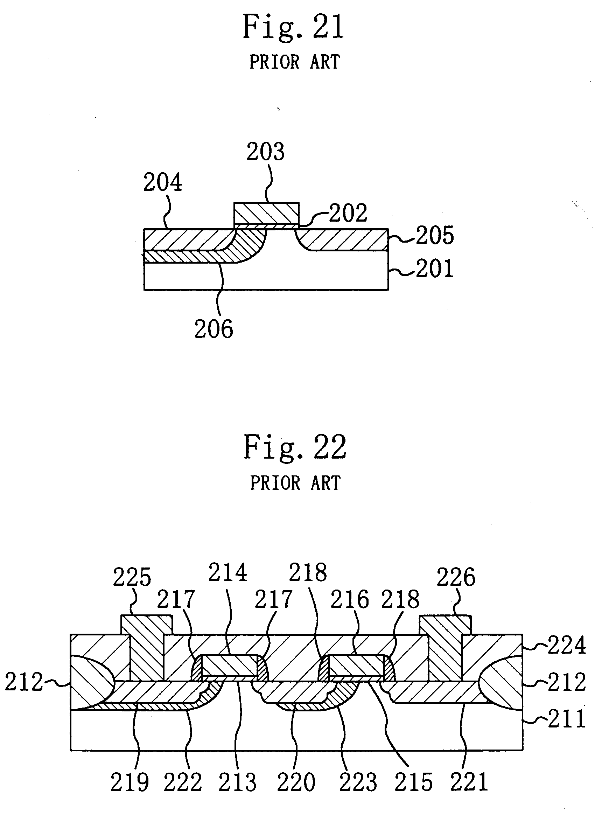

FIGS. 21 shows the cross-sectional structure of the conventional MOS semiconductor device with the LDC structure. As shown in the drawing, a gate electrode 203 is formed on a P-type semiconductor substrate 201 with a gate oxide film 202 interposed therebetween. A high-concentration N-type impurity source diffusion layer 204 and a high-concentration N-type impurity drain diffusion layer 205 are formed at both ends of the gate length in the semiconductor substrate 201. A high-concentration P-type impurity diffusion layer 206 for threshold control is formed to underlie the high-concentration impurity source diffusion layer 204 as well as the portion of the gate electrode 203 closer to the high-concentration impurity source diffusion layer 204.

Since the high-concentration P-type impurity diffusion layer 206 for threshold control has thus been formed under the high-concentration impurity source diffusion layer 204 as well as the portion of the gate electrode 203 closer to the high-concentration impurity source diffusion layer 204 such that the concentration of a P-type impurity gradually decreases therein as the distance from the high-concentration N-type source diffusion layer 204 increases under the gate electrode 203, resistance to the short-channel effect is improved in the region of the semiconductor substrate 201 underlying the gate electrode 203 and closer to the high-concentration N-type impurity source diffusion layer 204, while the intensity of a high electric field is reduced in the region of the semiconductor substrate 201 closer to the high-concentration N-type impurity drain diffusion layer 205, which suppresses the generation of hot carriers. As a result, the conventional low-concentration LDD structure becomes no more necessary and a high driving ability is achieved.

FIG. 22 shows the cross-sectional structure of a semiconductor device composed of a plurality of MOS transistors with the conventional LDC structure. As shown in the drawing, an isolation region 212 made of a LOCOS film or the like is formed in a P-type semiconductor substrate 211. On an element formation region surrounded by the isolation region 212, first and second gate electrodes 214 and 216 are formed with intervention of first and second gate oxide films 213 and 215, respectively. First gate sidewalls 217 are formed on the individual side walls of the first gate electrode 214. Second gate sidewalls 218 are formed on the individual side walls of the second gate electrode 216.

In the semiconductor substrate 211, a first N-type impurity source diffusion layer 219 is formed on the side of the first gate electrode 214 opposite to the second gate electrode 216. A second source diffusion layer 220, which also serves as a first N-type impurity drain diffusion layer 220, is formed in a region of the semiconductor substrate 211 located between the first and second gate electrodes 214 and 216. A second N-type impurity drain diffusion layer 221 is formed on the side of the second gate electrode 216 opposite to the first gate electrode 214.

In the semiconductor substrate 211, a first P-type impurity diffusion layer 222 for threshold control is formed under the first N-type impurity source diffusion layer 219 as well as the portion of the first gate electrode 214 closer to the first N-type impurity source diffusion layer 219, while a second P-type impurity diffusion layer 223 for threshold control is formed under the second N-type impurity source diffusion layer 220 as well as the portion of the second gate electrode 216 closer to the second N-type impurity source diffusion layer 220.

An interlayer insulating film 224 having respective contact holes for exposing the first N-type impurity source diffusion layer 219 and the second N-type impurity drain diffusion layer 221 is formed on the semiconductor substrate 211. A first wire 225 is formed of aluminum filled in the contact hole for exposing the first N-type impurity source diffusion layer 219. A second wire 226 is formed of aluminum filled in the contact hole for exposing the second N-type impurity drain diffusion layer 221.

However, in the foregoing conventional semiconductor device composed of the MOS transistors, parasitic capacitance between the source electrode and the substrate is increased in the presence of the P-type impurity diffusion layer under the N-type impurity source diffusion layer. Thus, the speed of an element is reduced if a logic circuit is composed thereof in which a voltage is placed between the source electrode and the substrate, such as a NAND-gate CMOS circuit, since the speed of the MOS semiconductor device is directly proportional to the product of the reciprocal of the value of a saturation current and a load capacitance.

Moreover, since the power consumption of the MOS semiconductor device is directly proportional to the product of the load capacitance and the square of an applied voltage, the power consumption of the circuit is increased disadvantageously.

### SUMMARY OF THE INVENTION

It is therefore an object of the present invention to eliminate the conventional disadvantages and achieve a higher operating speed and lower power consumption even when design rules on the sub-quartermicron order or under are used in a logic circuit.

To achieve the foregoing object, the present invention provides a semiconductor device comprising a plurality of MIS transistors, wherein an impurity diffusion region for threshold control is formed under each of the gate electrodes placed in parallel on a semiconductor substrate such that the concentration of an impurity in the impurity diffusion region gradually decreases in the direction of carrier drift, thereby providing a gradient.

A first semiconductor device according to the present invention comprises; a single semiconductor substrate; and a plurality of MIS transistors formed on the semiconductor substrate, one of the MIS transistors of a first conductivity type having a source region connected in series to a drain region of another of the MIS transistors of the first conductivity type, the MIS transistors having respective gate electrodes placed in parallel with each other on the semiconductor substrate and respective channel regions formed in the semiconductor substrate to underlie the individual gate electrodes such that carriers drift in the same direction in each of the channel regions, a concentration of an impurity of a second conductivity type being higher in a portion of each of the channel regions closer to the source region than in a portion of each of the channel regions closer to the drain region.

In the first semiconductor device, the MIS transistors of one conductivity type are formed on the single semiconductor substrate and the source region of one of the MIS transistors of the first conductivity type is connected in series to the drain region of another of the MIS transistors of the first conductivity type. In addition, carriers drift in the same direction in each of the channel regions formed under the respective gate electrodes. Moreover, since the concentration of the impurity of the second conductivity type is higher in the source-side portion of each of the channel regions than in the drain-side region thereof, a potential at the source-side portion of the channel region is held high, though voltages applied to the MIS transistors connected in series are lower than the power-source voltage. Therefore, the driving abilities of the MIS transistors connected in series are not lowered and a desired operating speed and lower power consumption are achieved even when the power-source voltage is reduced.

Since the MIS transistors of the first conductivity type connected in series have the respective gate electrodes placed in parallel with each other, higher integration is easily achieved. Furthermore, the manufacturing cost is not increased since the impurity of the second conductivity type can be implanted in a single step during the formation of a region containing an impurity of the second conductivity type at a high concentration in the source-side portion of each of the channel regions.

A second semiconductor device according to the present invention comprises: a single semiconductor substrate; and a NAND circuit formed on the semiconductor substrate, the NAND circuit being composed of two P-channel MOS transistors each having source and drain regions connected in parallel to source and drain regions of the other P-channel MOS transistor, respectively, and of two N-channel MOS transistors each having a source region connected in series to a drain region of the other N-channel MOS transistor, the two N-channel MOS transistors having respective gate electrodes placed in parallel with each other on the semiconductor substrate and respective channel regions formed in the semiconductor substrate to underlie the individual gate electrodes such that carriers drift in the same direction in each of the channel regions, a concentration of a p-type impurity being higher in a portion of each of the channel regions closer to the source region than in a portion of each of the channel regions closer to the drain region.

In the second semiconductor device, the four MOS transistors composing the NAND circuit include the two N-channel MOS transistors each having the source region connected in series to the drain region of the other N-channel MOS transistor. The two N-channel MOS transistors have the respective channel regions in each of which the carriers drift in the same direction. Since the concentration of the impurity of the first conductivity type is higher in the source-side portion of each of the channel regions than in the drain-side portion thereof and the gate electrodes are placed in parallel with each other, the second semiconductor device can achieve the same effects as achieved by the first semiconductor device.

A third semiconductor device according to the present invention comprises: a single semiconductor substrate; and a NOR circuit formed on the semiconductor substrate, the NOR circuit being composed of two P-channel MOS transistors each having a source region connected in series to a drain region of the other P-channel MOS transistor and of two N-channel MOS transistors each having source and drain regions connected in parallel to source and drain regions of the other N-channel MOS transistor, respectively, the two P-channel MOS transistors having respective gate electrodes placed in parallel with each other on the semiconductor substrate and respective channel regions formed in the semiconductor substrate to underlie the individual gate electrodes such that carriers drift in the same direction in each of the channel regions, a concentration of an n-type impurity being higher in a portion of each of the channel regions closer to the source region than in a portion of each of the channel regions closer to the drain region.

In the third semiconductor device, the four MOS transistors composing the NOR circuit include the two N-channel MOS transistors each having the source region connected in series to the drain region of the other N-channel MOS transistor. The two N-channel MOS transistors have the respective channel regions in each of which carriers drift in one direction. Since the concentration of the N-type impurity is higher in the source-side portion of each of the channel regions than in the drain-side portion thereof and the gate electrodes are placed in parallel with each other, the third semiconductor device can achieve the same effects as achieved by the first semiconductor device.

A fourth semiconductor device according to the present invention comprises: a single semiconductor substrate; and a compound logic circuit formed on the semiconductor substrate, the compound logic circuit including a plurality of N-channel MOS transistors, one of the N-channel MOS transistors having a source region connected in series to a drain region of another of the N-channel MOS transistors, the N-channel MOS transistors having respective gate electrodes placed in parallel with each other on the semiconductor substrate and respective channel regions formed in the semiconductor substrate to underlie the individual gate electrodes such that carriers drift in the same direction in each of the channel regions, a concentration of a P-type impurity being higher in a portion of each of the channel regions closer to the source region than in a portion of each of the channel regions closer to the drain region.

In the fourth semiconductor device, the logic circuit includes the MOS transistors of the first conductivity type having the channel regions formed under the respective gate electrodes such that carriers drift in the same direction in each of the channel regions. Since the concentration of the impurity of the second conductivity type is higher in the source-side portion of each of the channel regions than in the drain-side portion thereof and the gate electrodes are placed in parallel, the same effects as achieved by the first semiconductor device can be achieved.

A fifth semiconductor device according to the present invention comprises: a single semiconductor substrate; and a plurality of MIS transistors formed on the semiconductor substrate, one of the MIS transistors of a first conductivity type having a source region connected in series to a drain region of another of the MIS transistors of the first conductivity type, one of the MIS transistors of a second conductivity type having a source region connected in series to a drain region of another of the MIS transistors of the second conductivity type, the MIS transistors of the first conductivity type having respective gate electrodes placed in parallel with each other on the semiconductor substrate and respective channel regions of the first conductivity type formed in the semiconductor substrate to underlie the individual gate electrodes such that carriers drift in the same direction in each of the channel regions of the first conductivity type, a concentration of an impurity of the second conductivity type being higher in a portion of each of the channel regions of the first conductivity type closer to the source region than in a portion of each of the channel regions of the first conductivity type closer to the drain region, the MIS transistors of the second conductivity type having respective gate electrodes placed in parallel with each other on the semiconductor substrate; and respective channel regions of the second conductivity type formed in the semiconductor substrate to underlie the individual gate electrodes such that carriers drift in the same direction in each of the channel regions of the second conductivity type, a concentration of an impurity of the first conductivity type being higher in a portion of each of the channel regions of the second conductivity type closer to the source region than in a portion of each of the channel regions of the second conductivity type closer to the drain region.

In the fifth semiconductor device, the MIS transistors of the first conductivity type and the MIS transistors of the second conductivity type have the same structures as used in the first semiconductor device. Accordingly, the MIS transistors of the first conductivity type and the MIS transistors of the second conductivity type can achieve the same effects as achieved by the first semiconductor device.

In the fifth semiconductor device, the first conductivity type is preferably a P type, the second conductivity type is preferably an N type, and the MIS transistors are preferably MOS transistors, the semiconductor device preferably comprising: an inverter circuit composed of a first P-channel MOS transistor and a first N-channel MOS transistor included in the MOS transistors; and a clocked inverter circuit composed of a second P-channel MOS transistor connected in series between a source electrode of the first P-channel MOS transistor and a power-source voltage terminal to be controlled by a clock signal and a second N-channel MOS transistor connected in series between a source electrode of the first N-channel MOS transistor and a ground voltage terminal to be controlled by a complementary clock signal. In the arrangement, the first and second P-channel MOS transistors and the first and second N-channel MOS transistors in the clocked inverter circuit have the same structures as used in the first semiconductor device, so that the clocked inverter circuit achieves the same effects as achieved by the first semiconductor device.

Preferably, the fifth semiconductor device further comprises a flip-flop circuit including the clocked inverter circuit. In the arrangement, the flip-flop circuit can achieve the same effects as achieved by the first semiconductor device.

A sixth semiconductor device according to the present invention comprises: a single semiconductor substrate; and a DRAM circuit formed on the substrate, the DRAM circuit being constituted by a memory cell array unit composed of an array of numerous memory cells for holding data and by a peripheral circuit unit for controlling read/write operations performed with respect to the memory cell array unit, the peripheral circuit unit having a decoder circuit including a NAND circuit composed of a plurality of P-channel MOS transistors, one of the P-channel MOS transistors having source and drain regions connected in parallel to source and drain regions of another of the P-channel MOS transistors, respectively, and of a plurality of N-channel MOS transistors, one of the N-channel MOS transistors having a source region connected in series to a drain region of another of the N-channel MOS transistors and a NOR circuit composed of a plurality of P-channel MOS transistors, one of the P-channel MOS transistors having a source region connected in series to a drain region of another of the P-channel MOS transistors, and of a plurality of N-channel MOS transistors, one of the N-channel MOS transistors having source and drain regions connected in parallel to source and drain regions of another of the N-channel MOS transistors, respectively, the N-channel MOS transistors composing the NAND circuit having respective gate electrodes placed in parallel with each other on the semiconductor substrate and respective N-type channel regions formed in the semiconductor substrate to underlie the individual gate electrodes such that carriers drift in the same direction in each of the N-type channel regions, a concentration of a P-type impurity being higher in a portion of each of the N-type channel regions closer to the source region than in a portion of each of the N-type channel regions closer to the drain region, the P-channel MOS transistors composing the NOR circuit having respective gate electrodes placed in parallel with each other on the semiconductor substrate and respective P-type channel regions formed in the semiconductor substrate to underlie the individual gate electrodes such that carriers drift in the same direction in each of the P-type channel regions, a concentration of an N-type impurity being higher in a portion of each of the P-type channel regions closer to the source region than in a portion of each of the P-type channel regions closer to the drain region.

In the sixth semiconductor device, the decoder circuit in the peripheral circuit unit of the DRAM circuit has the NAND circuit and NOR circuit having the same structure as used in the first semiconductor device. Accordingly, the N-channel MOS transistors of the NAND circuit and the P-channel MOS transistors of the NOR circuit can achieve the same effects as achieved by the first semiconductor device.

A seventh semiconductor device according to the present invention comprises: a single semiconductor substrate; and a plurality of MIS transistors of a first conductivity type formed on the semiconductor substrate, the MIS transistors of the first conductivity type having respective gate electrodes placed in parallel with each other and respective source and drain regions formed at both ends of respective lengths of the gate electrodes, a channel region being formed under the gate electrode of one of the MIS transistors of the first conductivity type such that carriers drift in one direction in the channel region, a concentration of an impurity of a second conductivity type being higher in a portion of the channel region closer to the source region than in a portion of the channel region closer to the drain region.

In the seventh semiconductor device, the MIS transistors have the respective gate electrodes placed in parallel with each other and one of the MIS transistors has the channel region formed under the gate electrode in which carriers drift in one direction. In addition, the concentration of the impurity of the second conductivity type is higher in the source-side portion of the channel region than in the drain-side portion thereof, so that a potential at the source-side portion of the channel region is increased, which improves the driving ability of the MIS transistor. As a result, a desired operating speed and lower power consumption are achieved even when the power-source voltage is reduced.

Moreover, since the MIS transistors have the respective gate electrodes placed in parallel with each other, higher integration is easily achieved. Furthermore, the manufacturing cost is not increased since the impurity is implanted in a single step during the formation of a region containing an impurity of the second conductivity type at a high-concentration in the source-side portion of each of the channel regions.

In the seventh semiconductor device, a concentration of the impurity of the second conductivity type is preferably higher in a portion of a channel region of another of the MIS transistors closer to the source region than in a portion thereof closer to the drain region. In the arrangement, the properties of the element are not adversely affected even when carriers drift in two directions in another of the MIS transistors. This ensures the formation of a region containing an impurity of the second conductivity type at a high concentration in the source-side portion of each of the channel regions in a single step of ion implantation using a single mask pattern.

An eighth semiconductor device according to the present invention comprises: a single semiconductor substrate; and a transmission gate circuit formed on the semiconductor substrate, the transmission gate circuit being constituted by an inverter circuit composed of a first P-channel MOS transistor and a first N-channel MOS transistor having respective drain regions connected to each other and by a transfer gate circuit composed of a second P-channel MOS transistor and a second N-channel MOS transistor having respective source regions and respective drain regions connected in parallel to each other to receive an output from the inverter circuit, the first and second P-channel MOS transistors having respective gate electrodes placed in parallel with each other and the first and second N-channel MOS transistors having respective gate electrodes placed in parallel with each other, a P-type channel region being formed under the gate electrode of the first P-channel MOS transistor such that carriers drift in one direction in the P-type channel region, a concentration of an N-type impurity being higher in a portion of the P-type channel region closer to a source region than in a portion of the P-type channel region closer to a drain region, an N-type channel region being formed under the gate electrode of the first N-channel MOS transistor such that carriers drift in one direction in the N-type channel region, a concentration of a P-type impurity being higher in a portion of the N-type channel region closer to a source region than in a portion of the N-type channel region closer to a drain region.

In the eighth semiconductor device, the P-type channel region in which carriers drift in one direction is formed under the gate electrode of the first P-channel MOS transistor composing the inverter circuit such that the concentration of the N-type impurity is higher in the source-side portion of the P-type channel region than in the drain-side portion thereof. On the other hand, the N-type channel region in which carriers drift in one direction is formed under the gate electrode of the first N-channel MOS transistor composing the inverter circuit such that the concentration of the P-type impurity is higher in the source-side portion of the N-type channel region than in the drain-side portion thereof. Moreover, the first and second P-channel MOS transistors have the respective gate electrodes placed in parallel with each other, while the first and second N-channel MOS transistors have the respective gate electrodes placed in parallel with each other. Accordingly, the inverter circuit in the transmission gate circuit has the same structure as used in the seventh semiconductor device, so that the transmission gate circuit achieves the same effects as achieved by the seventh semiconductor device.

In the eighth semiconductor device, a concentration of the N-type impurity is preferably higher in a portion of a P-type channel region of the second P-channel MOS transistor closer to the source region than in a portion thereof closer to the drain region and a concentration of the P-type impurity is higher in a portion of an N-type channel region of the second N-channel MOS transistor closer to the source region than in a portion thereof closer to the drain region. In the arrangement, the properties of the element are not adversely affected even when carriers drift in two directions in the second P-channel or N-channel MOS transistor. This ensures the formation of a region containing an impurity opposite in conductivity type to the channel region at a high concentration in the source-side portion of each of the channel regions in a single step of ion implantation process using a single mask pattern.

A ninth semiconductor device according to the present invention comprises: a single semiconductor substrate; and a clocked inverter circuit constituted by a first inverter circuit composed of a first P-channel MOS transistor and a first N-channel MOS transistor connected to each other, the first inverter generating a complementary clock signal by inverting a clock signal inputted thereto, a second inverter circuit composed of a second P-channel MOS transistor and a second N-channel MOS transistor connected to each other, the second inverter circuit outputting an inverted signal obtained by inverting an input signal, and a transfer gate circuit composed of a third P-channel MOS transistor and a third N-channel MOS transistor connected in parallel to each other, the transfer gate circuit outputting the inverted signal under the control of the clock signal and the complementary clock signal, the first and second P-channel MOS transistors having respective gate electrodes placed in parallel with each other and the first and second N-channel MOS transistors having respective gate electrodes placed in parallel with each other, a P-type channel region being formed under the gate electrode of the first P-channel MOS transistor such that carriers drift in one direction in the P-type channel region, a concentration of an N-type impurity being higher in a portion of the P-type channel region closer to a source region than in a portion of the P-type channel region closer to a drain region, an N-type channel region being formed under the gate electrode of the first N-channel MOS transistor such that carriers drift in one direction in the N-type channel region, a concentration of a P-type impurity being higher in a portion of the N-type channel region closer to a source region than in a portion of the N-type channel region closer to a drain region.

In the ninth semiconductor device, the first and second P-channel MOS transistors and the first and second N-channel MOS transistors of the clocked inverter circuit have the same structures as used in the seventh semiconductor device. Accordingly, the first and second P-channel MOS transistors and the first and second N-channel MOS transistors can achieve the same effects as achieved by the seventh semiconductor device.

In the ninth semiconductor device, a concentration of the N-type impurity is preferably higher in a portion of a P-type channel region of the second P-channel MOS transistor closer to the source region than in a portion thereof closer to the drain region and a concentration of the P-type impurity is higher in a portion of an N-type channel region of the second N-channel MOS transistor closer to the source region than in a portion thereof closer to the drain region.

Preferably, the ninth semiconductor device further comprises a flip-flop circuit including the clocked inverter circuit.

In the arrangement, the flip-flop circuit can achieve the same effects as achieved by the seventh semiconductor device.

A method of manufacturing a semiconductor device according to the present invention comprises the steps of: sequentially depositing a gate insulating film and a conductive film over an entire surface of a semiconductor substrate of a first conductivity type; selectively etching the conductive film and the gate insulating film to expose a top surface of the semiconductor substrate and thereby forming a plurality of gate electrodes in parallel with each other on the semiconductor substrate, the gate electrodes being composed of the conductive film deposited on the semiconductor substrate with the gate insulating film interposed therebetween; implanting ions of an impurity of the first conductivity type into the semiconductor substrate by using the gate electrodes as a mask, the ions being supplied to a substrate surface at a tilt angle of 7° or more from a plane perpendicular to the substrate surface and parallel with a gate width toward one end of a gate length to form impurity diffusion layers for threshold control in respective regions of the semiconductor substrate underlying the gate electrodes such that a concentration of the impurity of the first conductivity type gradually decreases as a distance from one end of the gate length increases in each of the impurity diffusion layers; and implanting ions of an impurity of a second conductivity type into the semiconductor substrate by using the gate electrodes as a mask to form source and drain regions at both ends of the gate length in the semiconductor substrate.

In accordance with the method of manufacturing a semiconductor device, the formation of the gate electrodes in parallel with each other on the semiconductor substrate of the first conductivity type is followed by the implantation of impurity ions of the first conductivity type using the gate electrodes as mask, which is performed by supplying the impurity ions to the substrate surface at a tilt angle of 7° or more from a plane perpendicular to the substrate surface and parallel with the gate width toward one end of the gate length. What results is the impurity diffusion layer for threshold control formed in the semiconductor substrate to underlie each of the gate electrodes such that the concentration of the impurity of the first conductivity type gradually decreases as the distance from one end of the gate length increases. If carriers are caused to drift in the direction in which the concentration of the impurity of the first conductivity type gradually decreases, a transistor having a reduced area and a high driving ability can be implemented in a single step of implanting an impurity for threshold control. This allows the manufacturing of the first to ninth semiconductor devices according to the present invention at lower cost, each having an element formation region reduced in area, a high driving ability, and lower power consumption.

### BRIEF DESCRIPTION OF THE DRAWINGS

FIG. 1 is a plan view of a complementary MOS semiconductor device as a semiconductor device according to a first embodiment of the present invention, which is to serve as a 2-input NAND circuit;
FIG. 2 is a cross-sectional view showing the structure of the semiconductor device according to the first embodiment, which is taken along the line I-I of FIG. 1;
FIG. 3 is a cross-sectional view showing the structure of the semiconductor device according to the first embodiment, which is taken along the line II-II of FIG. 1;
FIG. 4 is a circuit diagram of the semiconductor device according to the first embodiment;
FIGS. 5(a) and 5(b) are cross-sectional views illustrating process steps in accordance with a method of manufacturing the semiconductor device according to the first embodiment;
FIGS. 6(a) and 6(b) are cross-sectional views illustrating process steps in accordance with the method of manufacturing the semiconductor device according to the first embodiment;
FIGS. 7(a) and 7(b) are cross-sectional views illustrating process steps in accordance with the method of manufacturing the semiconductor device according to the first embodiment;
FIG. 8 is a cross-sectional view illustrating a process step in accordance with the method of manufacturing the semiconductor device according to the first embodiment;
FIG. 9 is a plan view of a complementary MOS semiconductor device as a semiconductor device according to a second embodiment of the present invention, which is to serve as a 2-input NOR circuit;
FIG. 10 is a circuit diagram of the semiconductor device according to the second embodiment;
FIG. 11 is a circuit diagram of a complementary MOS semiconductor device as a semiconductor device according to a third embodiment of the present invention, which is to serve as an AND-NOR circuit in a compound logic circuit;
FIG. 12 is a plan view of a complementary MOS semiconductor device as a semiconductor device according to a fourth embodiment of the present invention, which is to serve as a clocked inverter circuit;
FIG. 13 is a circuit diagram of the semiconductor device according to the fourth embodiment;
FIG. 14 is a circuit diagram of a complementary MOS semiconductor device as a semiconductor device according to a fifth embodiment of the present invention, which is to serve as a data-latch flip-flop circuit;
FIG. 15 is a circuit diagram of a complementary MOS semiconductor device as a semiconductor device according to a sixth embodiment of the present invention, which is to serve as an 8-bit decoder circuit;
FIG. 16 is a plan view of a complementary MOS semiconductor device as a semiconductor device according to a seventh embodiment of the present invention, which is to serve as a transmission gate circuit;
FIG. 17 is a circuit diagram of the semiconductor device according to the seventh embodiment;
FIG. 18 shows the semiconductor device according to the seventh embodiment, which is taken along the line III-III of FIG. 16;
FIG. 19 is a cross-sectional view showing the structure of the semiconductor device according to the seventh embodiment, which is taken along the line IV-IV of FIG. 16;
FIG. 20 is a circuit diagram of a complementary MOS semiconductor device as a semiconductor device according to an eighth embodiment of the present invention, which is to serve as a clocked inverter circuit;
FIG. 21 is a cross-sectional view showing the structure of a conventional power MOS semiconductor device with an LDC structure; and
FIG. 22 shows the cross-sectional structure of a conventional semiconductor device composed of a plurality of MOS transistors having the LDC structure.

### DETAILED DESCRIPTION OF THE INVENTION

In a semiconductor device disclosed in the present application, a portion of a channel region extending from a source region to the center of the channel region will be termed a source-side portion, while a portion of the channel region extending from a drain region to the center of the channel region will be termed a drain-side portion.

In the semiconductor device according to the present invention, the concentration of an impurity in an impurity diffusion layer formed in the channel region of a semiconductor substrate under a gate electrode varies along the channel length. Specifically, the concentration of the impurity in the channel region gradually decreases as the distance from the source region increases. Consequently, an electric field formed in the source-side portion of the channel region when a voltage is placed between the source and drain regions is increased in intensity compared with the case where the impurity concentration in the channel region is uniform along the channel length.

In a region using design rules on the subquartermicron order, the electric field becomes sufficiently intense in the source-side portion of the channel region, so that carriers experience a velocity overshoot in the source-side portion of the channel region. The velocity overshoot is a phenomenon in which carriers gain high energy from the electric field and reach a non-equilibrium high energy state before incurring a velocity loss due to lattice scattering or impurity scattering and are thereby transported at a velocity higher than a saturation velocity, which is the velocity of carriers in an equilibrium state.

In a MOS semiconductor substrate, the value of a saturation current is determined by the product of the velocity and density of carriers in the source-side portion of the channel region. Therefore, the present invention causes the velocity overshoot in the source-side portion of the channel region to increase the saturation current to a value higher than achieved in the conventional semiconductor device. Since the velocity overshoot occurs only in the drain-side portion of the channel region in the conventional semiconductor device, the value of the saturation current is not increased.

### (First Embodiment)

A first embodiment of the present invention will be described with reference to the drawings.

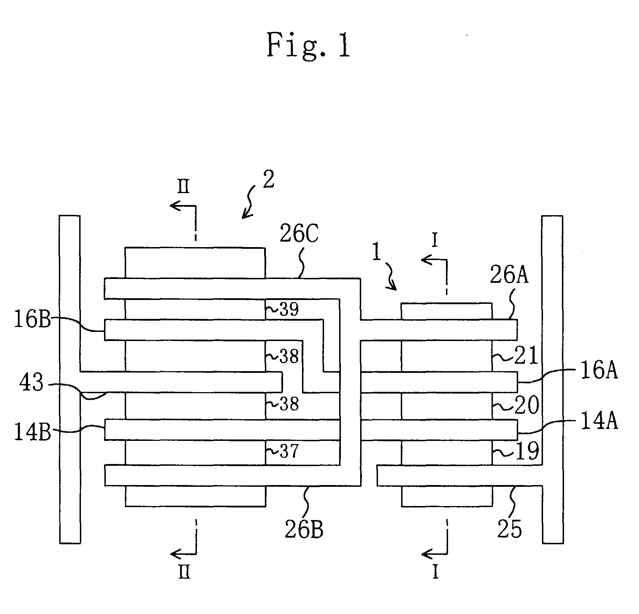

FIG. 1 shows the plan configuration of a complementary MOS semiconductor device as a semiconductor device according to the first embodiment, which is to serve as a 2-input NAND circuit. As shown in the drawing, a first gate electrode 14A serving as one input terminal and a second gate electrode 16A serving as the other input terminal are placed in parallel with each other on an N-channel MOS transistor formation region 1 provided in a semiconductor substrate made of P-type silicon. In the N-channel MOS transistor formation region 1, a first N-type impurity source diffusion layer 19 is formed on the side of the first gate electrode 14A opposite to the second gate electrode 16A. A second N-type impurity source diffusion layer 20, which also serves as a first N-type impurity drain diffusion layer 20, is formed between the first and second gate electrodes 14A and 16A. A second N-type impurity diffusion layer 21 is formed on the side of the second gate electrode 16A opposite to the first gate electrode 14A. Thus, the two N-channel MOS transistors are connected in series with the first N-type impurity drain diffusion layer 20 also serving as the second N-type impurity source diffusion layer 20. A first wire 25 made of aluminum is formed on the first N-type impurity source diffusion layer 19 so that the ground potential is applied thereto. A second wire 26A made of aluminum is formed on the second N-type impurity drain diffusion layer to output the result of operation performed by the circuit.

On a P-channel MOS transistor formation region 2, a third gate electrode 14B serving as one input terminal and a fourth gate electrode 16B serving as the other input terminal are placed in parallel with each other. In the P-channel MOS transistor formation region 2, a first P-type impurity drain diffusion layer 37 is formed on the side of the third gate electrode 14B opposite to the fourth gate electrode 16B. A second P-type impurity source diffusion layer 38, which also serves as a first P-type impurity source diffusion layer 38, is formed between the third and fourth gate electrodes 14B and 16B. A second P-type impurity drain diffusion layer 39 is formed on the side of the fourth gate electrode 16B opposite to the third gate electrode 14B. Third and fourth wires 26B and 26C, each made of aluminum, are formed on the first and second P-type impurity drain diffusion layers 37 and 39, respectively, to be connected to the second wire 26A. A fifth wire 43 made of aluminum is formed on the first/second P-type impurity source diffusion layer 38 so that a power-source potential Vdd is applied thereto. From the arrangement, it will be understood that the two P-channel MOS transistors are connected in parallel.

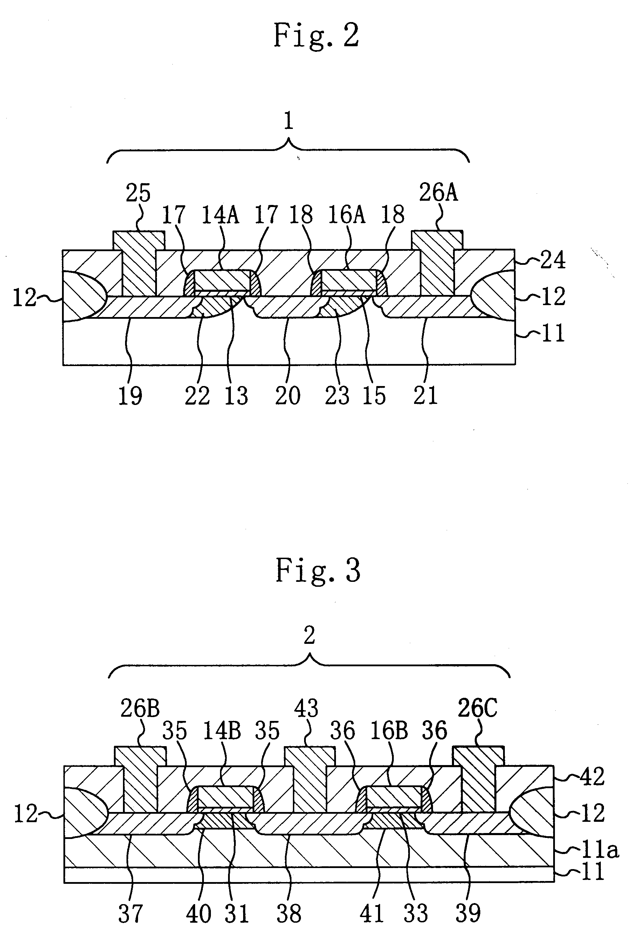

FIG. 2 shows a cross-sectional structure taken along the line I-I of FIG. 1. FIG. 3 shows a cross-sectional structure taken along the line II-II of FIG. 1.

In FIGS. 2 and 3, the description of the same components as shown in FIG. 1 is omitted by providing the same reference numerals.

As shown in FIG. 2, an isolation region 12 composed of a LOCOS film or the like is formed in a semiconductor substrate 11 made of P-type silicon. In the N-channel MOS transistor formation region 1 surrounded by the isolation region 12, the first gate electrode 14A and the second gate electrode 16A are formed with intervention of a first gate insulating film 13 and a second gate insulating film 15, respectively. First gate sidewalls 17 are formed on the individual side walls of the first gate electrode 14A. Second gate sidewalls 18 are formed on the individual side walls of the second gate electrode 16A.

A first P-type impurity diffusion layer 22 for threshold control is formed in a region of the semiconductor substrate 11 underlying the portion of the first gate electrode 14A closer to the first N-type impurity source diffusion layer 19, i.e., in the source-side portion of the first channel region. A second P-type impurity diffusion layer 23 for threshold control is formed in a region underlying the portion of the second gate electrode 16A closer to the second N-type impurity source diffusion layer 20.

An interlayer insulating film 24 having respective contact holes for exposing the first and second N-type impurity source diffusion layers 19 and 21 is formed on the semiconductor substrate 11.

As shown in FIG. 3, an N-well diffusion layer 11a is formed in the P-type semiconductor substrate 11 by implanting an N-type impurity such as arsenic ions. In the N-well diffusion layer 11a, the isolation region 12 composed of a LOCOS film or the like is formed. In the P-channel MOS transistor formation region 2 surrounded by the isolation region 12, the third gate electrode 14B and the fourth gate electrode 16B are formed with intervention of a third gate insulating film 31 and a fourth gate insulating film 33, respectively. Third gate sidewalls 35 are formed on the individual side walls of the third gate electrode 14B. Fourth gate sidewalls 36 are formed on the individual side walls of the fourth gate electrode 16B.

A first N-type impurity diffusion layer 40 for threshold control is formed to have a uniform impurity concentration in a portion of the N-well diffusion layer 11a underlying the third gate electrode 14B, i.e., in a third channel region. A second N-type impurity diffusion layer 41 for threshold control is formed to have a uniform impurity concentration in a portion of the N-well diffusion layer 11a underlying the fourth gate electrode 16B, i.e., in a fourth channel region.

On the semiconductor substrate 11, an interlayer insulating first 42 having respective contact holes for exposing the P-type impurity drain diffusion layer 37, the first/second P-type impurity source diffusion layer 38, and the second P-type impurity drain diffusion layer 39 is formed.

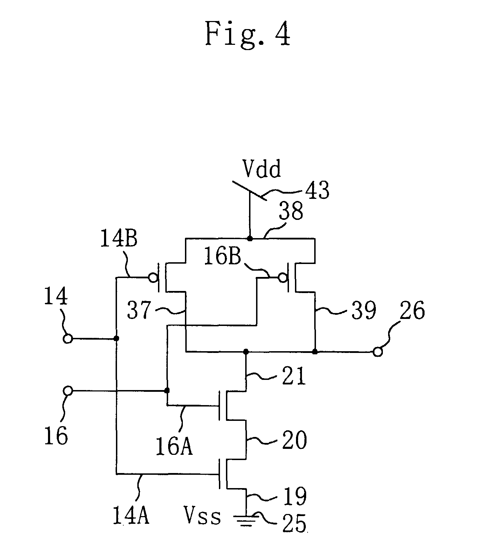

FIG. 4 shows the circuit configuration of the 2-input NAND circuit, in which the description of the same components as shown in FIG. 1 is omitted by providing the same reference numerals. In FIG. 4, a first input terminal 14 is connected to the first and third gate electrodes 14A and 14B. A second input terminal 16 is connected to the second and fourth gate electrodes 16A and 16B. An output terminal 26 is connected to the second, third, and fourth wires 26A, 26B, and 26C.

Thus, in the N-channel MOS transistor formation region 1 of the complementary semiconductor device composing the 2-input NAND circuit according to the present embodiment, electrons as carriers constantly drift in one direction from the first N-type impurity source diffusion layer 19 to the second N-type impurity drain diffusion layer 21 through the first/second N-type impurity drain/source diffusion layer 20.

Moreover, since the first and second P-type impurity diffusion layers 22 and 23 are formed in the semiconductor substrate 11 to underlie the first and second gate electrodes 14A and 16A, respectively, the concentration of a P-type impurity is higher in the source-side portion of each of the channel regions than in the drain-side portion thereof. Consequently, the value of a saturation current for the MOS transistor is larger than in the case where the concentration of a P-type impurity is uniform throughout the channel region, while resistance to hot carriers is improved. In addition, the driving ability is not significantly reduced even during operation at a low voltage.

Furthermore, since the regions of the first and second P-type impurity diffusion layers 22 and 23 each containing the impurity at a high concentration have not extended to underlie the first and second source diffusion layers 19 and 20 in the present embodiment, a parasitic capacitance between the source electrode and the substrate is lower than in the conventional MOS transistor with the LDC structure, so that the operating speed is not reduced, while power consumption is reduced.

A description will be given to the problems presented by the conventional MOS transistor with the LDC structure. As shown in FIG. 22, the first and second P-type impurity diffusion layers 222 and 223 for improving the voltage resistance of a power MOS are formed in the respective regions of the semiconductor substrate 211 underlying the first and second source diffusion layers 211 and 220. The impurity concentration in each of the P-type impurity diffusion layers 222 and 223 is adjusted to be 1 x 10¹⁸ cm⁻³ or more so as to suppress the short-channel effect in a region using design rules below the subquartermicron order. Since a parasitic capacitance at a pn junction formed between the source electrode and the substrate is increased accordingly compared with the case where the conventional LDD is used, the speed of an element is reduced if a logic circuit is composed thereof in which a voltage is placed between the source electrode and the substrate, such as a NAND-gate CMOS circuit.

The present embodiment is primarily characterized in that, because the two N-channel MOS transistors have the respective source and drain regions arranged in the same direction and the first and second gate electrodes 14A and 16A placed in parallel with each other as shown in the N-channel MOS transistor formation region 1 of FIG. 1, the first and second P-type impurity diffusion layers 22 and 23 can be formed in a single step of diffusion using a single mask, which is performed with respect to the regions of the semiconductor substrate 11 underlying the first and second gate electrodes 14A and 16A to produce a gradient in the concentration of the P-type impurity for threshold voltage in each of the underlying regions. This facilitates the manufacturing of a low-power semiconductor device operating at a high speed and having the N-channel MOS transistor formation region 1 reduced in area.

On the other hand, each of the first and second N-type impurity diffusion layers 40 and 41 formed under the third and fourth gate electrodes 14B and 16B has a uniform impurity concentration along the gate length in the P-channel MOS transistor formation region 2. Since a sufficient voltage is placed between the source and drain electrodes of each of the two P-channel MOS transistors connected in parallel, it is unnecessary to increase the driving ability by using a N-type impurity diffusion layer having a uniform impurity concentration. Additionally, the same manufacturing process as used conventionally can be used in the present embodiment.

Although the present embodiment has described the 2-input NAND circuit by way of example, it is not limited thereto. A multi-input NAND circuit or two or more N-channel MOS transistors connected in series can constitute a complementary semiconductor device having a high driving ability and a reduced parasitic capacitance during operation at a low voltage.

A method of manufacturing the semiconductor device according to the first embodiment will be described with reference to the drawings.

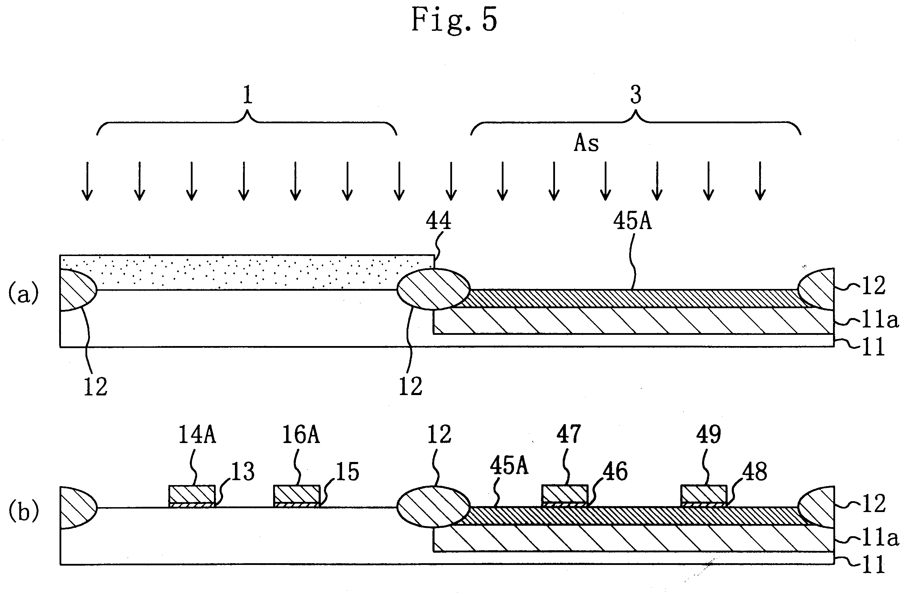

FIGS. 5 to 8 are cross-sectional views illustrating the method of manufacturing the semiconductor device according to the first embodiment. First, as shown in FIG. 5(a), the isolation region 12 for isolating the N-channel MOS transistor formation region 1 and a P-channel MOS transistor formation region 3 from each other is formed in the semiconductor substrate 11 made of P-type silicon. The P-channel MOS transistor formation region 3 used here is not necessarily an element complementary to the N-channel MOS transistor formation region 1. Then, a first resist pattern 44 for masking the N-channel MOS transistor formation region 1 of the semiconductor substrate 11 is formed such that ions of an N-type impurity, such as arsenic ions, are implanted into the P-channel MOS transistor formation region 3 of the semiconductor substrate 11 to form the N-well diffusion layer 11a. Arsenic ions are implanted continuously to form the N-type impurity diffusion layer 45A for controlling the threshold voltage of the P-channel MOS transistor. The step of forming the N-well diffusion layer is interchangeable with the step of forming the N-type impurity diffusion layer 45A.

Next, after the first resist pattern 44 is removed as shown in FIG. 5(b), a gate insulating film composed of a silicon oxide film or the like and a conductive film made of polysilicon or the like are deposited on the semiconductor substrate 11, which are then patterned as specified to form the first, second, third, and fourth gate electrodes 14A, 16A, 47, and 49 with intervention of the first, second, third, and fourth gate insulating films 13, 15, 46, and 48, respectively.

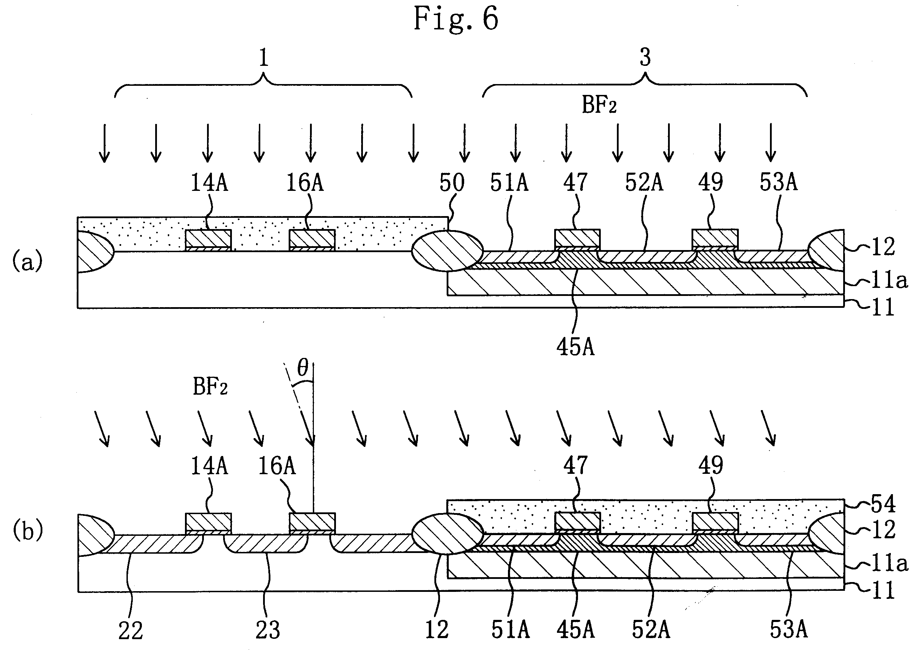

Next, as shown in FIG. 6(a), a second resist pattern 50 for masking the N-channel MOS transistor formation region 1 of the semiconductor substrate 11 is formed. Then, by using the second resist pattern 50 and the third and fourth gate electrodes 47 and 49 as a mask, ions of a P-type impurity such as BF₂ ions are implanted into the P-channel MOS transistor formation region 3 of the semiconductor substrate 11 at an implant dose of approximately 2.0 x 10¹⁴ cm⁻² and with implant energy of 10 KeV, so that shallow P-type impurity source/drain diffusion layers 51A, 52A, and 53A (so-called extensions) are formed.

Next, as shown in FIG. 6(b), the removal of the second resist pattern 50 is followed by the formation of a third resist pattern 54 for masking the P-channel MOS transistor formation region 3 of the semiconductor substrate 11. Then, by using the third resist pattern 54 and the first and second gate electrodes 14A and 16A as a mask, BF₂ ions are implanted into the N-channel MOS transistor formation region 1 of the semiconductor substrate 11 at an implant dose of approximately 2.0 x 10¹³ cm⁻² and with implant energy of 80 KeV. During implantation, the BF₂ ions are supplied to the substrate surface at a tilt angle θ of 7° or more from a plane perpendicular to the substrate surface and parallel with the gate width toward the N-channel MOS transistor formation region 1. As a result, the first and second P-type impurity diffusion layers 22 and 23 for threshold control are formed under the first and second gate electrodes 14A and 16A such that the impurity concentration in each of the first and second P-type impurity diffusion layers 22 and 23 decreases in the same direction. Since the BF₂ ions are supplied at a tilt angle θ of 7° or more toward the N-channel MOS transistor formation region 1, the impurity concentration in each of the first and second P-type impurity diffusion layers 22 and 23 for threshold control gradually decreases in the same direction.

The tilt angle θ has been set at 7° or more because the angle at which ions are implanted is not perpendicular to the substrate surface but tilted at about 7° from a normal to the substrate surface in a typical ion implantation process. Therefore, the tilt angle θ should be 7° or more to form a P-type impurity diffusion layer having a gradient impurity concentration in the source-side portion of the channel region. Although the tilt angle θ varies depending on the distance between the first and second gate electrodes 14A and 16A placed in parallel and on the vertical dimensions thereof, the second P-type impurity diffusion layer 23 should not be shielded by the first gate electrode 14A even when the tilt angle θ is maximum. Thus, it is necessary to optimize the tilt angle θ in accordance with design rules or the like.

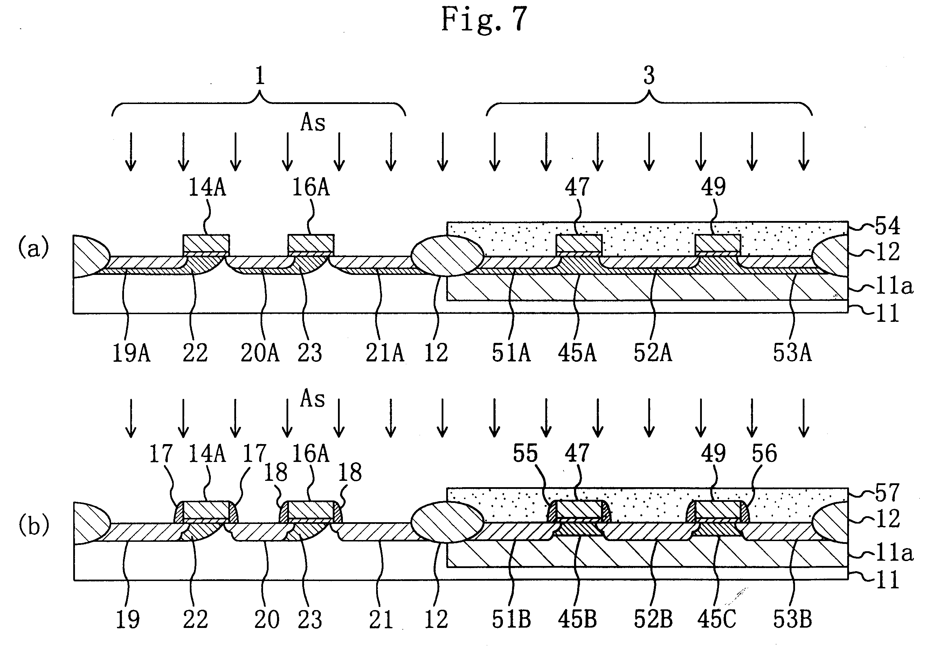

Next, as shown in FIG. 7(a), by using the third resist pattern 54 and the first and second gate electrodes 14A and 16A as a mask, ions of an N-type impurity such as arsenic ions are implanted into the N-channel MOS transistor formation region 1 of the semiconductor substrate 11 at an implant dose of approximately 2.0 x 10¹⁴ cm⁻² and with implant energy of 10 KeV so that shallow source/drain diffusion layers 19A, 20A, and 21A are formed in the N-channel MOS transistor formation region 1.

Next, after the third resist pattern 54 is removed as shown in FIG. 7(b), an insulating film (not shown) composed of a silicon oxide film or the like is formed to a thickness of about 80 nm over the entire surface of the semiconductor substrate 11. The insulating film is then subjected to anisotropic dry etching for forming the first, second, third, and fourth gate sidewalls 17, 18, 55, and 56 on the respective side walls of the first, second, third, and fourth gate electrodes 14A, 16A, 47, and 49. Thereafter, a fourth resist pattern (not shown) for masking the N-channel MOS transistor formation region 1 of the semiconductor substrate 11 is formed. Then, by using the fourth resist pattern, the third gate electrode 47 with the third gate sidewalls 55, and the fourth gate electrode 49 with the fourth sidewalls 56 as a mask, BF₂ ions are implanted into the P-channel MOS transistor formation region 3 of the semiconductor substrate 11 at an implant dose of approximately 2.0 x 10 ¹⁵cm⁻² and with implant energy of 30 KeV. As a result, deep P-type impurity source/drain diffusion layers 51B, 52B, and 53B are formed, while first and second N-type impurity diffusion layers 45B and 45C for threshold control each having a uniform impurity concentration are formed in the semiconductor substrate 11 to underlie the third and fourth gate electrodes 47 and 49.

After that, the fourth resist pattern is removed and a fifth resist pattern 57 for masking the P-channel MOS transistor formation region 3 of the semiconductor substrate 11 is formed. Then, by using the fifth resist pattern 57, the first gate electrode 14A with the first gate sidewalls 17, and the second gate electrode 16A with the second gate sidewalls 18 as a mask, arsenic ions are implanted into the N-channel MOS transistor formation region 1 of the semiconductor substrate 11 at an implant dose of approximately 6.0 x 10¹⁵ cm⁻² and with implant energy of 40 KeV so that deep N-type impurity source/drain diffusion layers are formed in the N-channel MOS transistor formation region 1. Specifically, the first N-type impurity source diffusion layer 19 is formed on the side of the first gate electrode 14A opposite to the second gate electrode 16A, the second N-type impurity source diffusion layer 20, which also functions as the first N-type impurity drain diffusion layer 20, is formed between the first and second gate electrodes 14A and 16A, and the second N-type impurity drain diffusion layer 21 is formed on the side of the second gate electrode 16A opposite to the first gate electrode 14A.

It is to be noted that the step of forming the source/drain diffusion layers in the N-channel MOS transistor formation region 1 is interchangeable with the step of forming the source/drain diffusion layers in the P-channel MOS transistor formation region 3.

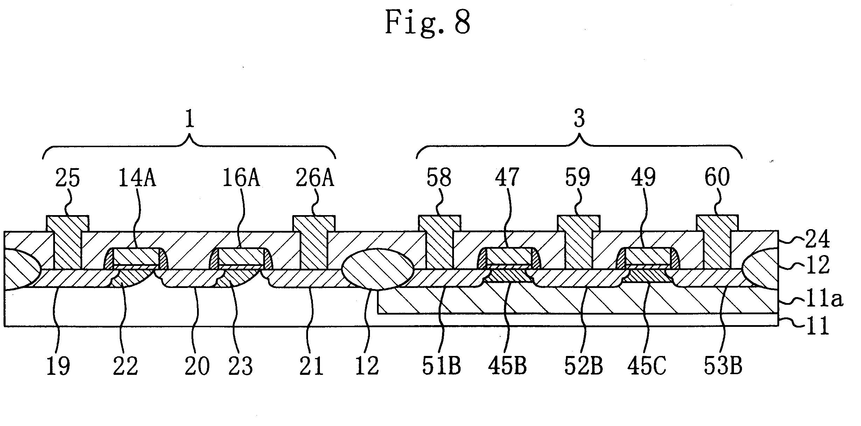

Next, as shown in FIG. 8, the removal of the fifth resist pattern 57 is followed by the deposition of the interlayer insulating film 24 over the entire surface of the semiconductor substrate 11. Subsequently, the first and second wires 25 and 26A, each made of aluminum, are formed respectively on the first N-type impurity source diffusion layer 19 and on the second N-type impurity drain diffusion layer 21 in the first N-channel MOS transistor formation region 1, while the third, fourth, and fifth wires 58, 59, and 60, each made of aluminum, are formed respectively on the P-type impurity source/drain diffusion layers 51B, 52B, and 53B in the P-channel MOS transistor formation region 3.

As described above, carriers constantly move from the source side to the drain side as specified in the pair of N-channel MOS transistors connected in series of the 2-input NAND circuit. In the method of manufacturing the semiconductor device according to the present embodiment, therefore, ions of a P-type impurity are implanted into the N-channel MOS transistor formation region 1 by using the first and second gate electrodes 14A and 16A placed in parallel as a mask such that the ions are supplied to the substrate surface at a tilt angle θ of 7° or more from the plane perpendicular to the substrate surface and parallel with the gate width toward the N-channel MOS transistor formation region 1. This allows the first and second P-type impurity diffusion layers 22 and 23 for threshold control to be formed in the respective channel regions of the semiconductor substrate 11 underlying the first and second gate electrodes 14A and 16A such that the respective impurity concentrations therein gradually decrease in the same direction from the source side to the drain side.

By thus implanting the P-type impurity ions for threshold control at a tilt angle of 7° or more from a normal to the substrate surface toward the N-channel MOS transistor formation region 1, the pair of N-channel MOS transistors having the P-type impurity diffusion layers with a gradient impurity concentration can be formed easily and reliably in a single step of implantation. In the respective P-type impurity diffusion layers, the impurity concentrations gradually decrease in the same direction from the source side to the drain side.

The concentration of a P-type impurity in each of the regions underlying the first and second N-type impurity source diffusion layers 19 and 20 in the semiconductor substrate 11 is adjusted to be lower than the impurity concentration in the source-side portion of the channel region. Consequently, the source-to-substrate capacitance is lower than in the LDC structure used for the conventional power MOS, resulting in a higher operating speed and lower power consumption.

By thus laying out a logic circuit composed of a plurality of MOS transistors connected in series and having gate electrodes placed in parallel such that carriers constantly drift in a specified direction, an element formation region reduced in area, a higher driving ability, and lower power consumption can be implemented at lower cost.

### (Second Embodiment)

A second embodiment of the present invention will be described with reference to the drawings.

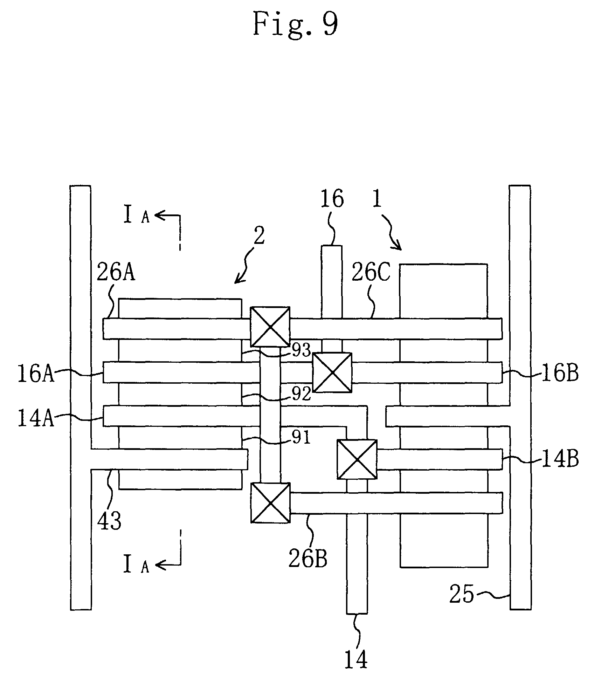

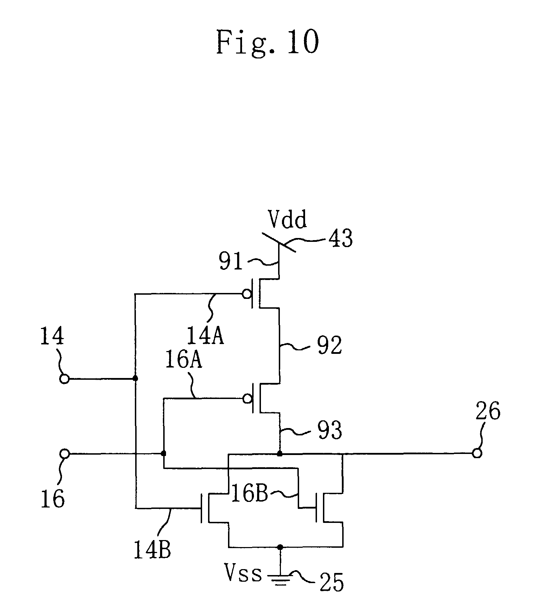

FIG. 9 shows a plan configuration of a complementary MOS semiconductor device as a semiconductor device according to the second embodiment, which is to serve as a 2-input NOR circuit. FIG. 10 shows the circuit configuration of the 2-input NOR circuit. In FIGS. 9 and 10, the description of the same component as shown in FIG. 1 is omitted by providing the same reference numerals. As shown in FIG. 10, the 2-input NOR circuit is implemented by switching the conductivity types between the pair of MOS transistors connected in series and the pair of MOS transistors connected in parallel, so that the two PMOS transistors are connected in series. Therefore, as shown in FIG. 9, a first gate electrode 14A connected to a first input terminal 14 and a second gate electrode 16A connected to a second input terminal are placed in parallel in a P-channel MOS transistor formation region 2 provided in a semiconductor substrate made of P-type silicon. In the P-channel MOS transistor formation region 2, a first P-type impurity source diffusion layer 91 is formed on the side of the first gate electrode 14A opposite to the second gate electrode 16A. A second P-type impurity source diffusion layer 92, which also serves as a first P-type impurity drain diffusion layer 92, is formed between the first and second gate electrodes 14A and 16A. A second P-type impurity drain diffusion layer 93 is formed on the side of the second gate electrode 16A opposite to the first gate electrode 14A.

In each of respective channel regions formed under the first and second gate electrodes 14A and 16A in the substrate, the concentration of an N-type impurity for threshold control is adjusted to be higher in the source-side portion of the channel region than in the drain-side portion thereof, as might be observed in a cross section taken along the line IA-IA of FIG. 9 of which the drawing is omitted here. Consequently, the value of a saturation current in the P-channel MOS transistor is larger than in the case where the concentration of an N-type impurity is uniform throughout the channel region, resulting in improved resistance to hot carriers. Moreover, the driving ability is not reduced significantly even during operation at a low voltage. In accordance with the method of implanting an N-type impurity for threshold control at a non-uniform concentration in each of the channel regions, ions of the N-type impurity are supplied to the substrate surface at a tilt angle θ of 7° or more from a plane perpendicular to the substrate surface and parallel with the gate width toward the N-channel MOS transistor formation region 1, similarly to the first embodiment.

Moreover, since a sufficient voltage is placed between the source and drain electrodes of each of the two N-channel MOS transistors connected in parallel in the N-channel MOS transistor formation region 1 as shown in FIG. 9, it is unnecessary to increase the driving ability by forming a P-type impurity diffusion layer for threshold control having a gradient impurity concentration. Additionally, the same manufacturing process as used conventionally can be used in the present embodiment.

Although the present embodiment has described the 2-input NOR circuit by way of example, it is not limited thereto. A multi-input NOR circuit or two or more P-channel MOS transistors connected in series can constitute a complementary semiconductor device having a high driving ability and a reduced parasitic capacitance during operation at a low voltage.

By thus laying out a logic circuit composed of a plurality of P-channel MOS transistors connected in series and having gate electrodes placed in parallel such that carriers constantly drift in a specified direction, an element formation region reduced in area, a higher driving ability, and lower power consumption can be implemented at lower cost.

### (Third Embodiment)

Referring to the drawings, a third embodiment of the present invention will be described with reference to the drawings.

In general, every logic circuit can be represented by simply combining a NOT circuit (i.e., an inverter circuit) consisting of one P-channel MOS transistor and one N-channel MOS transistor connected in series with the foregoing NAND or NOR circuit. A more complicated logic circuit can be implemented by a single logic gate circuit consisting of a plurality of MOS transistors that have selectively been connected in series or in parallel. Such a logic gate circuit is termed a compound logic gate circuit.

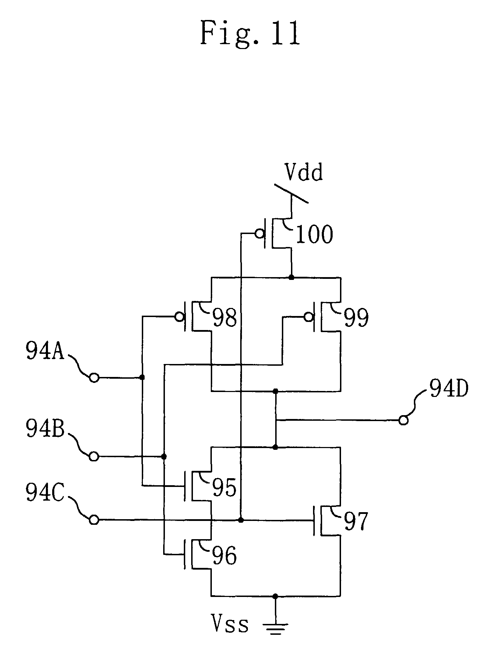

FIG. 11 shows the circuit configuration of a complementary MOS semiconductor device as a semiconductor device according to the third embodiment, which is to serve as an AND-NOR circuit among compound logic circuits. As shown in the drawing, a first N-channel MOS transistor 95 having a gate electrode connected to a first input terminal 94A is connected in series to a second N-channel MOS transistor 96 having a gate electrode connected to a second input terminal 94B in the AND-NOR circuit, while a third N-channel MOS transistor 97 having a gate electrode connected to a third input terminal 94C is connected in parallel to the first and second N-channel MOS transistors 95 and 96.

A first P-channel MOS transistor 98 having a gate electrode connected to the first input terminal 94A is connected in parallel to a second P-channel MOS transistor 99 having a gate electrode connected to the second input terminal 94B, while a third P-channel MOS transistor 100 having a gate electrode connected to the third input terminal 94C is connected in series between a common source electrode for the first and second P-channel MOS transistors 98 and 99 and a power-source voltage terminal Vdd. An output terminal 94D is connected to a common drain electrode for the first to third N-channel MOS transistors 95, 96, and 97 and to a common drain electrode for the first and second P-channel MOS transistors 98 and 99.

A logical AND operation is performed with respect to signals inputted to the first and second input terminals 94A and 94B. The result of the logical AND operation and a signal inputted to the third input terminal 94C are subjected to a logical NOR operation and the result of the logical NOR operation is outputted to the output terminal 94D.

The AND-NOR circuit according to the present embodiment is formed on a semiconductor substrate made of P-type silicon. The first and second N-channel MOS transistors 95 and 96 connected in series have the respective gate electrodes placed in parallel. Since carriers constantly drift in one direction from the source side to the drain side in each of respective channel regions formed under the two N-channel MOS transistors 95 and 96 and the concentration of a P-type impurity for threshold control is adjusted to be higher in the source-side portion of each of the channel regions than in the drain-side portion thereof, the value of a saturation current in each of the N-channel MOS transistors is larger than in the case where the concentration of a P-type impurity is uniform along each of the channel regions, resulting in improved resistance to hot carriers. Moreover, the driving ability is not reduced significantly even during operation at a low voltage.

Although the present embodiment has described the AND-NOR circuit as an exemplary compound logic gate circuit, it is not limited thereto. Another compound logic gate circuit can constitute a complementary semiconductor device having a high driving ability and a reduced parasitic capacitance during operation at a low voltage.

### (Fourth Embodiment)

A fourth embodiment of the present invention will be described with reference to the drawings.

Logic circuits include a static logic circuit which constantly holds a signal in response to an input, as described above, and a dynamic logic circuit which periodically operates under the control of a clock signal supplied from the outside. The present embodiment will describe a clocked inverter circuit controlled by the clock signal.

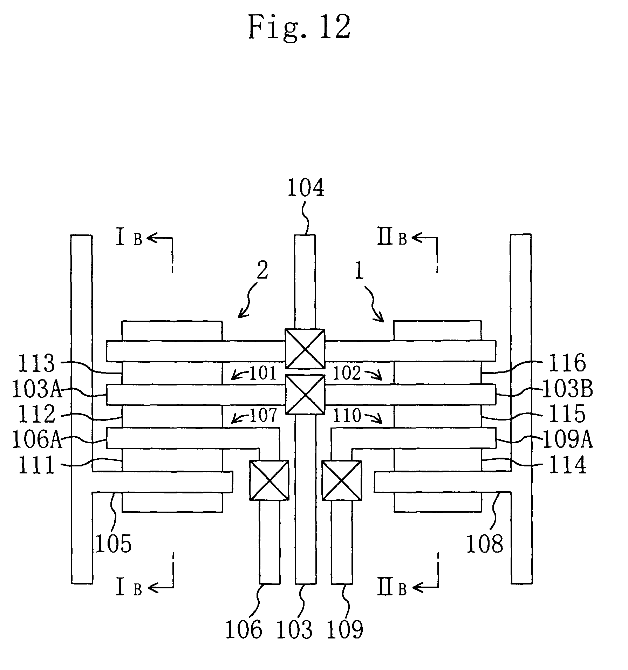

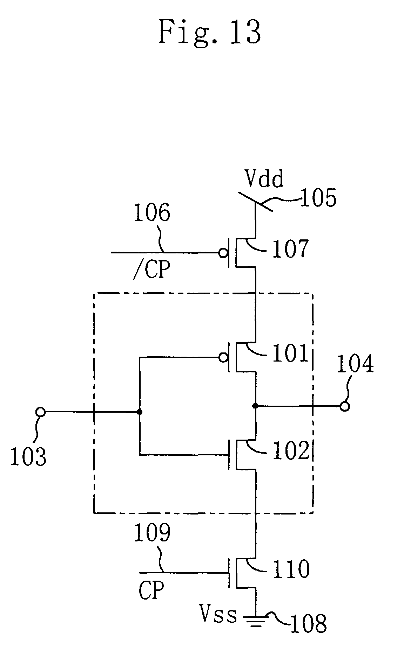

FIG. 12 shows the plan configuration of a complementary MOS semiconductor device as a semiconductor device according to the fourth embodiment, which is to serve as the clocked inverter circuit. FIG. 13 shows a circuit configuration of the clocked inverter. As shown in FIG. 13, the clocked inverter has an inverter consisting of a first P-channel MOS transistor 101 and a second N-channel MOS transistor 102 having respective gate electrodes connected to an input terminal 103 and respective drain electrodes connected to an output terminal 104. A second P-channel MOS transistor 107 gaining control from a complementary clock signal line 106 and interposed between the source electrode of the first P-channel MOS transistor 101 and a power-source voltage terminal 105 is connected in series to the inverter, while a second N-channel MOS transistor 110 gaining control from a clock signal line 109 and interposed between the source electrode of the first N-channel MOS transistor 102 and a ground voltage terminal 108 is connected in series to the inverter.

The semiconductor device according to the present embodiment is structurally characterized in that, in a P-channel MOS transistor formation region 2 provided in a semiconductor substrate made of P-type silicon, the first gate electrode 103A of the first P-channel MOS transistor 101, which is connected to the input terminal 103, and the second gate electrode 106A of the second P-channel MOS transistor 107, which is connected to the complementary clock signal line 106, are placed in parallel with each other, while the third gate electrode 103B of the first N-channel MOS transistor 102, which is connected to the input terminal 103, and the fourth gate electrode 109A of the second N-channel MOS transistor 110, which is connected to the clock signal line 109, are placed in parallel with each other, as shown in the plan view of FIG. 12.

In the P-channel MOS transistor formation region 2, moreover, a first P-type impurity source diffusion layer 111 is formed on the side of the second gate electrode 106A opposite to the first gate electrode 103A. A second P-type impurity source diffusion layer 112, which is to serve as a first P-type impurity drain diffusion layer 112, is formed between the first and second gate electrodes 103A and 106A. A second P-type impurity drain diffusion layer 113 is formed on the side of the first gate electrode 103A opposite to the second gate electrode 106A.

In an N-channel MOS transistor formation region 1, on the other hand, a first N-type impurity source diffusion layer 114 is formed on the side of the fourth gate electrode 109A opposite to the third gate electrode 103B. A second N-type impurity source diffusion layer 115, which also serves as a first N-type impurity drain diffusion layer 115, is formed between the third and fourth gate electrodes 103B and 109A. A second N-type impurity drain diffusion layer 116 is formed on the side of the third gate electrode 103B opposite to the fourth gate electrode 109A.

Referring to FIG. 13, a description will be given to the operation of the clocked inverter circuit. When a signal on the LOW level is inputted to the input terminal 103 and a clock pulse CP is on the HIGH level, a complementary clock signal /CP shifts to the LOW level, so that a current flows from the power-source voltage terminal 105 to the output terminal 104 so that a signal on the HIGH level is outputted. Conversely, when a signal on the HIGH level is inputted to the input terminal 103 and the clock pulse CP is on the HIGH level, a current flows from the output terminal 104 to the ground voltage terminal 108 so that a signal on the LOW level is outputted. Thus, carriers constantly drift in one direction in each of the first and second P-channel MOS transistors 101 and 107 connected in series and of the first and second N-channel MOS transistors 102 and 110 connected in series.

The semiconductor device according to the present embodiment is also structurally characterized in that, in a cross section taken along the line IB-IB of FIG. 12, the concentration of an N-type impurity for threshold control is adjusted to be higher in the source-side portion of each of the P-type channel regions formed in the substrate to underlie the first and second gate electrodes 103A and 106A than in the drain-side portion thereof. Likewise, in a cross section taken along the line IIB-IIB of FIG. 12, the concentration of a P-type impurity for threshold control is adjusted to be higher in the source-side portion of each of the N-type channel regions formed in the substrate to underlie the third and fourth gate electrodes 103B and 109A.

As a result, the value a saturation current in each of the P-channel MOS transistors 101 and 107 is increased compared with the case where the concentration of the N-type impurity is uniform throughout each of the P-type channel regions of the first and second P-channel MOS transistors 101 and 107, resulting in improved resistance to hot carriers. In addition, the driving ability is not reduced significantly even during operation at a low voltage. The same shall apply to the first and second N-channel MOS transistors 102 and 110.

It is to be noted that a method of providing a gradient impurity concentration for threshold control in each of the channel region is the same as used in the first embodiment.

Although the present embodiment has described the clocked inverter circuit as an exemplary dynamic logic circuit using a CMOS, it is not limited thereto. A dynamic logic circuit having a NAND or NOR circuit in place of an inverter circuit portion can constitute a complementary semiconductor device having a high driving ability and a reduced parasitic capacitance during operation at a low voltage.

By thus laying out a logic circuit composed of a plurality of P-channel or N-channel MOS transistors connected in series and having gate electrodes placed in parallel such that carriers constantly drift in a specified direction, an element formation region reduced in area, a higher driving ability, and lower power consumption can be implemented at lower cost.

### (Fifth Embodiment)

Referring to the drawings, a fifth embodiment of the present invention will be described.

Logic circuits include a sequential circuit in addition to a combinational circuit composed of a NAND circuit, a NOR circuit, and the like. An output value from the sequential circuit is determined not only by a present input value but also by a previous output value and hence includes a storage circuit in any form. The storage circuit is basically constituted by flip-flop circuits including a data-latch flip-flop circuit, a toggle flip-flop circuit, and a set-reset flip-flop circuit, which are selectively used in accordance with their functions.

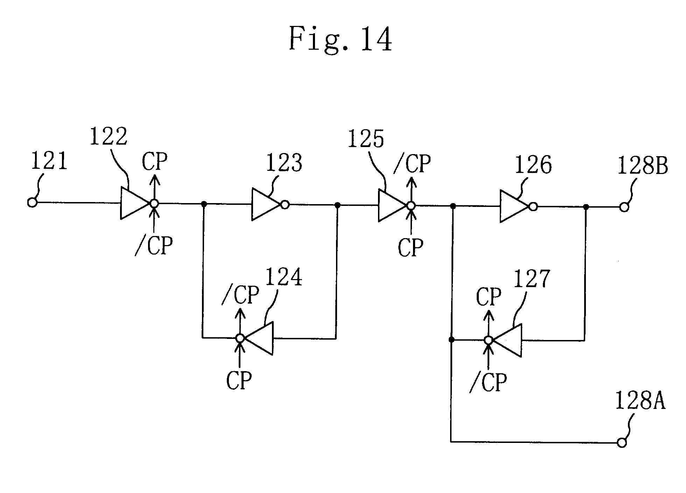

FIG. 14 shows the circuit configuration of a complementary CMOS circuit as a semiconductor device according to the fifth embodiment, which is to serve as a data-latch flip-flop circuit. As shown in the drawing, the semiconductor device according to the present embodiment comprises: a first clocked inverter circuit 122 connected to an input terminal 121 to invert an input signal in synchronism with a clock pulse CP and output an inverted signal; a first inverter circuit 123 connected to an output terminal of the first clocked inverter circuit 122 to invert an input signal and output an inverted signal; a second clocked inverter circuit 124 for receiving the output signal from the first inverter circuit 123, inverting the output signal in synchronism with the clock pulse CP, and returning an inverted signal to an input terminal of the first inverter circuit 123; a third clocked inverter circuit 125 connected to an output terminal of the first inverter circuit 123 to invert an input signal in synchronism with the clock pulse CP and output an inverted signal to a first output terminal 128A; a second inverter circuit 126 connected to an output terminal of the third clocked inverter circuit 125 to invert an input signal and output an inverted signal to a second output terminal 128B; and a fourth clocked inverter circuit 127 for receiving the output signal from the second inverter circuit 126, inverting the output signal in synchronism with the clock pulse CP, and returning an inverted signal to an input terminal of the second inverter circuit 126, while outputting the inverted signal to the first output terminal 128A.

A description will be given to the operation of the data-latch flip-flop circuit. If a signal on the HIGH level has been inputted to the input terminal 121, a potential at a node between the first clocked inverter circuit 122 and the first inverter circuit 123 is on the LOW level in response to a first clock pulse, while a potential at a node between the first inverter circuit 123 and the third clocked inverter circuit 125 is on the HIGH level. When a second clock pulse is inputted subsequently, a signal on the LOW level as a signal complementary to the input signal is outputted to the first output terminal 128A, while a signal on the same HIGH level as the input signal is outputted to the second output terminal 128B. Consequently, the input signal latched for one cycle is lagging behind the first clock pulse by one cycle, so that the signal complementary to the input signal is outputted to the first output terminal 128A, while a signal having the same polarity as the input signal is outputted to the second output terminal.

Since the first to fourth clocked inverter circuits 122, 124, 125, and 127 have the same structure as shown above in the fifth embodiment, there can be implemented a data-latch flip-flop circuit having a high driving ability and a reduced parasitic capacitance even during operation at a low voltage.

Although the present embodiment has described the data-latch flip-flop circuit by way of example, it is not limited thereto. The toggle flop-flop circuit and the set-reset flip-flop circuit may also be constituted by using an inverter circuit, a multi-input NAND circuit, a multi-input NOR circuit, a clocked inverter circuit, a transmission gate circuit, and a compound logic circuit. Similar effects can be achieved by applying, to each of the logic circuits composing the foregoing circuits, a novel technique used in the first embodiment, which is the technique of laying out a logic circuit composed of a plurality of MOS transistors connected in series and having respective gate electrodes placed in parallel such that carriers constantly drift in a specified direction in each of the channel regions in which the concentration of an impurity for threshold control is not uniform.

### (Sixth Embodiment)

A sixth embodiment of the present invention will be described.

A dynamic random-access memory (DRAM) circuit, which is a typical semiconductor storage circuit, is composed of a memory cell array unit consisting of a matrix of numerous memory elements, a peripheral circuit unit for controlling input/output operations (read/write operations) performed with respect to the memory array unit, and an input/output interface circuit unit. A decoder composing a typical circuit block in the peripheral circuit unit is constituted by a group of logic circuits receiving N (N is a positive integer) address signals and M (M is a positive integer) address signals from an address buffer in the input/output interface circuit unit and selecting an address consisting of one row and one column for specifying a memory cell in the memory cell array unit from addresses provided by 2^{N} column lines and 2^{M} row lines.

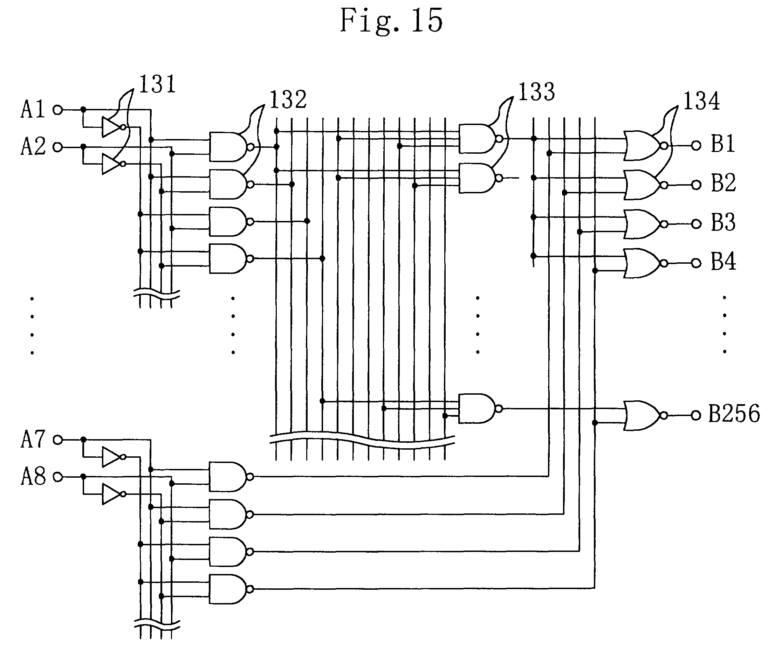

FIG. 15 shows the circuit configuration of a complementary MOS semiconductor device as a semiconductor device according to the sixth embodiment, which is to serve as an 8-bit decoder circuit. As shown in the drawing, an 8-bit input signal is inputted to input terminals A1 to A8 as a column address and one is selected from a group of 2⁸, i.e., 256 output terminals B1 to B256. The 8-bit decoder circuit comprises: eight inverter circuits 131 connected to the respective input terminals A1 to A8; sixteen 2-input NAND circuits 132 connected to output terminals of the inverter circuits 131; sixty-four 3-input NAND circuits 133 connected to output terminals of the 2-input NAND circuits 132; and two hundred and fifty-six 2-input NOR circuits 134 connected to output terminals of the 3-input NAND circuits 133.

Since each of the 2-input NAND circuits 132 and each of the 3-input NAND circuits 133 have the same structures as shown in the first embodiment and each of the 2-input NOR circuits 134 has the same structure as shown in the second embodiment, there can be implemented a decoder circuit having a high driving ability and a reduced parasitic capacitance even during operation at a low voltage.

Although the present embodiment has described the 8-bit decoder circuit by way of example, it is not limited thereto. A multi-bit decoder circuit other than the 8-bit decoder circuit can be constituted by using an inverter circuit, a multi-input NAND circuit, and a multi-input NOR circuit. Similar effects can be achieved by applying the novel technique described in detail in the first embodiment to each of the logic circuits composing the foregoing circuits.

### (Seventh Embodiment)

A seventh embodiment of the present invention will be described with reference to the drawings.

The first to sixth embodiments has laid out a logic circuit such as a NAND or NOR circuit, composed of a plurality of MOS transistors of one conductivity type which are connected in series and have gate electrodes placed in parallel such that carriers constantly drift in one direction. An impurity for threshold control has been implanted in the channel region formed under the gate electrode of each of the MOS transistors to have a gradient concentration, which increases the driving ability of each of the MOS transistors.

By contrast, the seventh embodiment will lay out a logic circuit composed of a plurality of MOS transistors of one conductivity type which are not connected in series and have gate electrodes placed in parallel such that carriers constantly drift in one direction. A gradient impurity concentration has been provided in the channel region of each of the MOS transistors, which increases the driving ability of each of the MOS transistors.

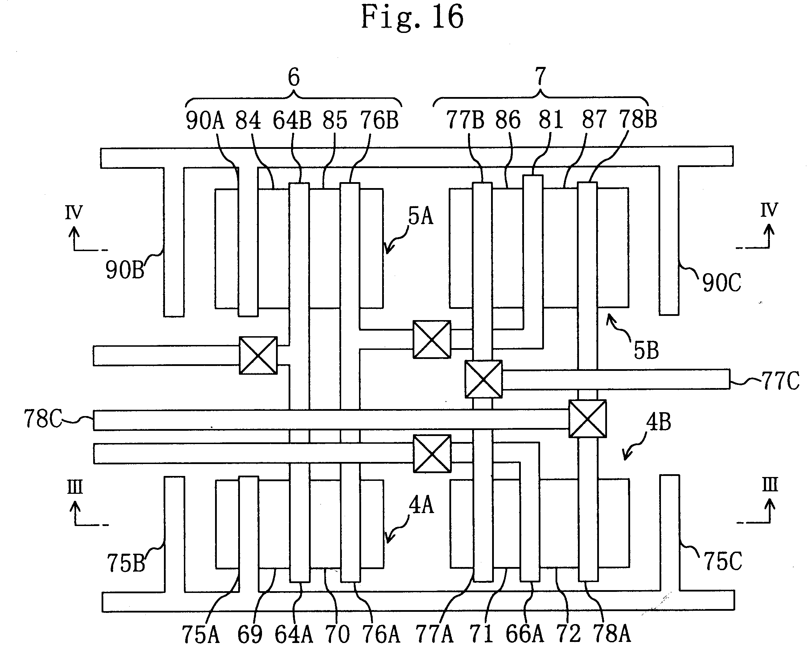

FIG. 16 shows the plan configuration of a complementary MOS semiconductor device as a semiconductor device according to the seventh embodiment. As shown in FIG. 16, a semiconductor substrate made of P-type silicon has been formed with an inverter circuit 6 composed of a first N-channel MOS transistor 4A and a first P-channel MOS transistor 5A and with a transfer gate circuit 7 composed of a second N-channel MOS transistor 4B and a second P-channel MOS transistor 5B.

The first N-channel MOS transistor 4A of the inverter circuit 6 is formed with a first gate electrode 64A composed of a conductive film made of polysilicon or the like to serve as one control terminal of the inverter circuit 6. A first N-type impurity source diffusion layer 69 and a first N-type impurity drain diffusion layer 70 are formed at both ends of the length of the first gate electrode 64A, in which arsenic ions or the like have been implanted. A first wire 75A made of aluminum to which the ground potential Vss is applied is connected to the first N-type impurity source diffusion layer 69. The ground potential Vss is also applied to second and third wires 75B and 75C connected to the substrate, thereby holding the substrate at the ground potential Vss.

The first P-channel MOS transistor 5A of the inverter circuit 6 is formed with a second gate electrode 64B composed of a conductive film made of polysilicon or the like to serve as the other control terminal of the inverter circuit 6. A first P-type impurity source diffusion layer 84 and a first P-type impurity drain diffusion layer 85 are formed at both ends of the length of the second gate electrode 64B, in each of which boron ions or the like have been implanted. A fourth wire 90A made of aluminum to which a power-source potential Vdd is applied is connected to the first P-type impurity source diffusion layer 84. The power-source potential Vdd is also applied to fifth and sixth wires 90B and 90C connected to the substrate, thereby holding the substrate at the power-source potential Vdd.

A seventh wire 76A connected to the first N-type impurity drain diffusion layer 70 of the first N-channel MOS transistor 4A and an eighth wire 76B connected to the first P-type impurity drain diffusion layer 85 of the first P-channel MOS transistor 5A, each made of aluminum, are connected in common to the transfer gate circuit 7.

In the inverter circuit 6 thus composed of the first N-channel MOS transistor 4A and the first P-channel MOS transistor 5A, carriers constantly drift in a specified direction.

The second N-channel MOS transistor 4B of the transfer gate circuit 7 is formed with a third gate electrode 66A composed of a conductive film made of polysilicon or the like to serve as one control terminal of the transfer gate circuit 7. A second N-type impurity source diffusion layer 71 and a second N-type impurity drain diffusion layer 72 are formed at both ends of the length of the third gate electrode 66A, in which arsenic ions or the like have been implanted.

The second P-channel MOS transistor 5B of the transfer gate circuit 7 is formed with a fourth gate electrode 81 composed of a conductive film made of polysilicon or the like to serve as the other control terminal of the transfer gate circuit 7 and receive an output value from the inverter circuit 6. A second P-type impurity source diffusion layer 86 and a second P-type impurity drain diffusion layer 87 are formed at both ends of the length of the fourth gate electrode 81, in each of which boron ions or the like have been implanted.

A ninth wire 77A connected to the second N-type impurity source diffusion layer 71 of the second N-channel MOS transistor 4B and a tenth wire 77B connected to the second P-type impurity source diffusion layer 86 of the second P-channel MOS transistor 5B, each made of aluminum, are connected in common to a first input/output terminal 77C of the logic circuit. Likewise, an eleventh wire 78A connected to the second N-type impurity drain diffusion layer 72 of the second N-channel MOS transistor 4B and a twelfth wire 78B connected to the second P-type impurity drain diffusion layer 87 of the second P-channel MOS transistor 5B, each made of aluminum, are connected in common to a second input/output terminal 78C of the logic circuit.

Hence, carriers drift in two directions in each of the second N-type impurity source diffusion layer 71 and second N-type impurity drain diffusion layer 72 of the second N-channel MOS transistor 4B depending on the value of a voltage applied to the first and second input/output terminals 77C and 78C, namely, a logic value. Likewise, carriers also drift in two directions in the second P-channel MOS transistor 5B.

Thus, in the transfer gate circuit 7 composed of the second N-channel MOS transistor 4B and the second P-channel MOS transistor 5B in which the flow of data is bi-directional, carrier drift changes in direction depending on the value of data inputted to the first and second input/output terminals 77C and 78C.

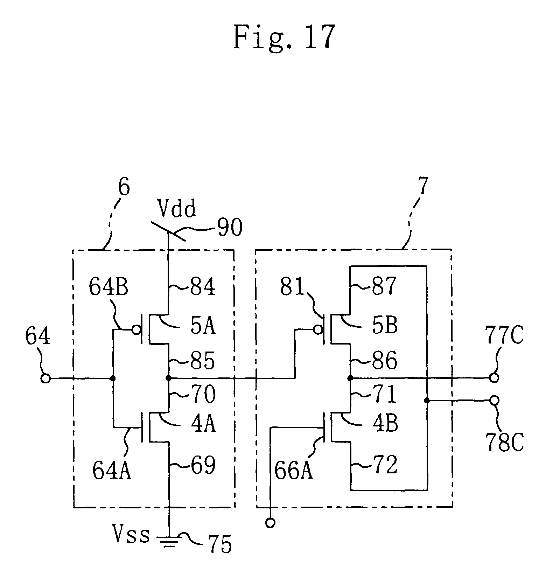

FIG. 17 shows the circuit configuration of the transmission gate circuit, in which the description of the same reference component as shown in FIG. 16 is omitted by providing the same reference numerals. In FIG. 17 are shown: a control terminal 64 connected to the first and second gate electrodes 64A and 64B; a ground voltage terminal 75 connected to the first, second, and third terminals 75A, 75B, and 75C; and a power-source voltage terminal 90 connected to the fourth, fifth, and sixth wires 90A, 90B, and 90C.

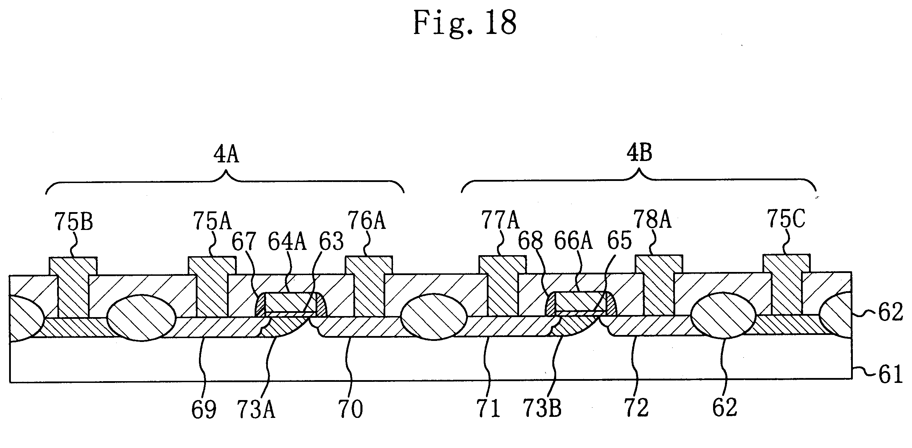

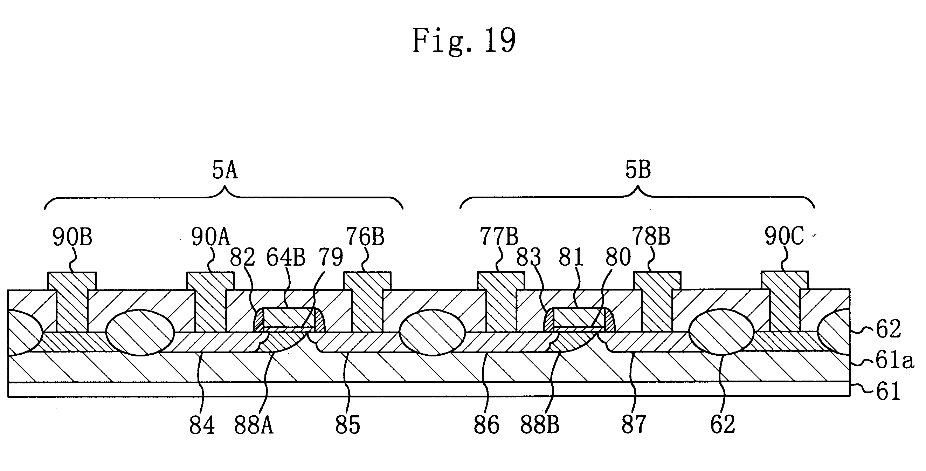

FIG. 18 shows a cross-sectional structure taken along the line III-III of FIG. 16. FIG. 19 shows a cross-sectional structure taken along the line IV-IV of FIG. 16.

In FIGS. 18 and 19, the description of the same components as shown in FIG. 16 is omitted by providing the same reference numerals.

As shown in FIG. 18, an isolation region 62 composed of a LOGOS film or the like is formed in a semiconductor substrate 61 made of P-type silicon. The first N-channel MOS transistor 4A surrounded by the isolation region 62 has the first gate electrode 64A formed with intervention of a first gate insulating film 63 and first gate sidewalls 67 made of an insulating film and formed on the individual side walls of the first gate electrode 64A. A first P-type impurity diffusion layer 73A is formed in a region of the semiconductor substrate 61 underlying the first gate electrode 64A, i.e., in a first channel region. In the first P-type impurity diffusion layer 73A, the concentration of a P-type impurity for threshold control gradually decreases as the distance from the first N-type impurity source diffusion layer 69 increases.

The second N-channel MOS transistor 4B surrounded by the isolation region 62 has the third gate electrode 66A formed with intervention of a third gate insulating film 65 and third gate sidewalls 68 made of an insulating film and formed on the individual side walls of the third gate electrode 66A. A second P-type impurity diffusion layer 73B is formed in a region of the semiconductor substrate 61 underlying the third gate electrode 66A, i.e., in a third channel region. In the second P-type impurity diffusion layer 73B, the concentration of a P-type impurity for threshold control gradually decreases as the distance from the second N-type impurity source diffusion layer 71 increases.

As shown in FIG. 19, the first P-channel MOS transistor 5A surrounded by the isolation region 62 and formed on an N-well diffusion layer 61a of the semiconductor substrate 61 has the second gate electrode 64B formed with intervention of a second gate insulating film 79 and second gate sidewalls 82 made of an insulating film and formed on the individual side walls of the second gate electrode 64B. A first N-type impurity diffusion layer 88A is formed in a region of the semiconductor substrate 61 underlying the second gate electrode 64B, i.e., in a second channel region. In the first N-type impurity diffusion layer 88A, the concentration of an N-type impurity for threshold control gradually decreases as the distance from the first P-type impurity source diffusion layer 84 increases.

Likewise, the second P-channel MOS transistor 5B formed on the N-well diffusion layer 61a of the semiconductor substrate 61 has the fourth gate electrode 81 formed with intervention of a fourth gate insulating film 80 and fourth gate sidewalls 83 made of an insulating film and formed on the individual side walls of the fourth gate electrode 81. A second N-type impurity diffusion layer 88B is formed in a region of the semiconductor substrate 61 underlying the fourth gate electrode 81, i.e., in a fourth channel region. In the second N-type impurity diffusion layer 88B, the concentration of an N-type impurity for threshold control gradually decreases as the distance from the second P-type impurity source diffusion layer 86 increases.

In the complementary semiconductor device composing the transmission gate circuit according to the present embodiment, electrons as carriers constantly drift in one direction from the first N-type impurity source diffusion layer 69 to the first N-type impurity drain diffusion layer 70 in the first N-channel MOS transistor 4A composing the inverter circuit 6. Likewise, holes as carriers constantly drift in one direction from the first P-type impurity source diffusion layer 84 to the first P-type impurity drain diffusion layer 85 in the first P-channel MOS transistor 5A composing the inverter circuit 6.

Since the first P-type impurity diffusion layer 73A and the first N-type impurity diffusion layer 88A are formed in the respective source-side portions of the channel regions of the first N-channel MOS transistor 4A and the first P-channel MOS transistor 5A, in each of which carriers drift in one direction as described above, the concentration of the P-type impurity for threshold control is higher in the source-side portion of each of the channel regions than in the drain-side portion thereof. Consequently, the value of a saturation current in the MOS transistor is increased compared with the case where the concentration of the P-type impurity is uniform throughout the channel region, resulting in improved resistance to hot carriers. Moreover, the driving ability is not significantly reduced even during operation at a low voltage.

In the present embodiment, the respective regions of the first P-type impurity diffusion layer 73A of the first N-channel MOS transistor 4A and the first N-type impurity diffusion layer 88A of the first P-channel MOS transistor 5A each containing the impurity at a high concentration have not extended to underlie the first N-type impurity source diffusion layer 69 and the first P-type impurity source diffusion layer 84. Consequently, a parasitic capacitance between the source electrode and the substrate is lower than in the conventional MOS transistor with the LDC structure, resulting in lower power consumption, while the operating velocity is not reduced.

The present embodiment is primarily characterized in that, if attention is given to the first N-channel MOS transistor 4A composing the inverter circuit 6 and to the second N-channel MOS transistor 4B composing the transfer gate circuit 7, in each of which carriers constantly drift in a specified direction, they have the first gate electrode 64A and the third gate electrode 66A placed in parallel, as shown in FIG. 16. Moreover, the high-concentration P-type impurity diffusion layers 73A and 73B are formed in the source-side portions of the respective channel regions of the first N-channel MOS transistor 4A and the second N-channel MOS transistor 4B, as shown in FIG. 18. As a result, the first and second P-type impurity diffusion layers 73A and 73B which impart a gradient in the concentration of the P-type impurity for threshold control can be formed in a single step of diffusion using a single mask. This facilitates the manufacturing of a low-power semiconductor device operating at a high speed and having the first and second N-channel MOS transistors 4A and 4B each reduced in area.

The same shall apply to the first P-channel MOS transistor 5A composing the inverter circuit 6 and the second P-channel MOS transistor 5B composing the transfer gate circuit 7, since what characterizes the semiconductor device according to the present embodiment characterizes any complementary circuit.

However, even if the impurity diffusion layer for threshold control has a gradient impurity concentration in the channel region of the second N-channel MOS transistor 4B or second P-channel MOS transistor 5B composing the transfer gate circuit 7, the electric properties thereof are not adversely affected. This is because carriers on the source side experience a velocity overshoot when the impurity concentration is higher on the source side, similarly to the inverter circuit 6, so that the electric properties are improved. When the impurity concentration is higher on the drain side, on the other hand, carriers on the source side do not experience a velocity overshoot but the electric properties are not degraded compared with the case where the impurity concentration is uniform.

Although the present embodiment has used the inverter circuit 6 as the circuit in which carriers constantly drift in one direction and the transfer gate circuit 7 as the circuit in which carriers drift in two directions, it is not limited thereto.

A description will be given to a method of manufacturing the semiconductor device thus constituted.

The transmission gate circuit as the semiconductor device according to the present embodiment can be implemented by using the same manufacturing method as used in the first embodiment, so that the description is given only to distinctive procedures. Since the layout as shown in the plan view of FIG. 16 is used, the first N-channel MOS transistor 4A and the second N-channel MOS transistor 4B have the first gate electrode 64A and the third gate electrode 66A placed in parallel with each other. Therefore, the first and second P-type impurity diffusion layers 73A and 73B, each of which has a gradient impurity concentration characterizing the present invention, can be formed in a single step of implantation wherein BF₂ ions as the P-type impurity are supplied to the substrate surface at a tilt angle of 7° or more from a plane perpendicular to the substrate surface and parallel with the gate width in the same manner as illustrated in FIG 5(b) according to the first embodiment.

Likewise, since the first P-channel MOS transistor 5A and the second P-channel MOS transistor 5B have the second gate electrode 64B and the fourth gate electrode 81 placed in parallel with each other, the first and second N-type impurity diffusion layers 88A and 88B, each of which has a gradient impurity concentration characterizing the present embodiment, can be formed in a single step of implantation wherein arsenic ions as the N-type impurity are supplied to the substrate surface at a tilt angle of 7 ° or more from a plane perpendicular to the substrate surface and parallel with the gate width.

By thus implanting impurity ions into the substrate at a tilt angle of 7° or more from a normal to the substrate surface toward the source diffusion layer, a pair of MOS transistors having the respective impurity diffusion layers for threshold control, each having a gradient impurity concentration in which the concentration of the impurity decreases as the distance from the impurity source diffusion layer increases, can be formed easily and reliably in a single step of implantation.

On the other hand, the concentration of the P-type impurity in each of the respective regions of the semiconductor substrate 61 underlying the first and second N-type impurity source diffusion layers 69 and 71 and the concentration of the N-type impurity in each of the respective regions of the semiconductor substrate 61 underlying the first and second P-type impurity source diffusion layers 84 and 86 are adjusted to be lower than the impurity concentration in the source-side portion of each of the channel regions. Accordingly, the source-to-substrate capacitance is lower than in the LDC structure used for the conventional power MOS, resulting in a higher operating speed and lower power consumption.

By thus laying out a logic circuit composed of a plurality of MOS transistors of one conductivity type having respective gate electrodes placed in parallel such that carriers constantly drift in a specified direction in one of the MOS transistors, an element formation region reduced in area, a higher driving ability, and lower power consumption can be implemented at lower cost.

### (Eighth Embodiment)

An eight embodiment of the present invention will be described with reference to the drawings.

Besides composing the clocked inverter circuit of two P-channel MOS transistors and two N-channel MOS transistors as has been described as an exemplary dynamic logic circuit in the fourth embodiment, it is also possible to compose a clock inverter circuit by combining two inverter circuits with a transfer gate circuit.

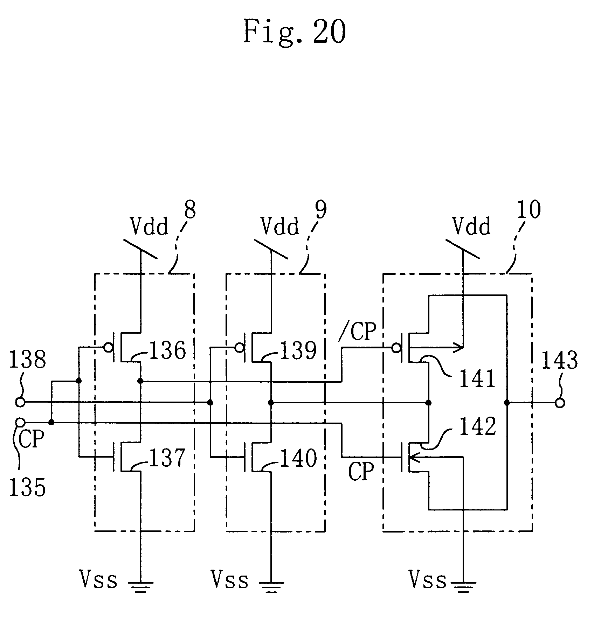

FIG. 20 shows the circuit configuration of a complementary MOS semiconductor device as a semiconductor device according to the eighth embodiment, which is to serve as a clocked inverter circuit. As shown in the drawing, the clocked inverter circuit comprises: a first inverter circuit 8 consisting of a first P-channel MOS transistor 136 and a first N-channel MOS transistor 137 having respective drain electrodes connected to each other to receive a clock pulse CP from a clock signal input terminal 135 and generate a complementary clock pulse /CP by inverting the inputted clock pulse CP; a second inverter circuit 9 consisting of a second P-channel MOS transistor 139 and a second N-channel MOS transistor 140 having respective drain electrodes connected to each other to receive an input signal from an input terminal 138 and output an inverted signal by inverting the input signal; and a transfer gate circuit 10 consisting of a third P-channel MOS transistor 141 under the control of the complementary clock pulse /CP and a third N-channel MOS transistor 142 under the control of the clock pulse CP, which have been connected in parallel, to output an inverted signal to an output terminal 143.

In each of the first and second P-channel MOS transistors 136 and 139 of the clocked inverter circuit according to the present embodiment, carriers constantly drift in one direction from the source electrode to the drain electrode. In each of the first and second N-channel MOS transistors 137 and 140 also, carriers similarly drift in one direction from the source electrode to the drain electrode. By contrast, carrier drift changes in direction depending on the value of an input signal in each of the third P-channel and N-channel MOS transistors 141 and 142 of the transfer gate circuit 10.

Hence, there can be implemented a clocked inverter circuit having a high driving ability and a low parasitic capacitance during operation at a low voltage if the first, second, and third P-channel MOS transistors 136, 139, and 141 are laid out to have respective gate electrodes arranged in parallel and the concentration of an N-type impurity for threshold control is adjusted to be higher in a source-side portion of a P-type channel region formed under each of the gate electrodes than in a drain-side portion thereof and if the first, second, and third N-channel MOS transistors 137, 140, and 142 are laid out to have respective gate electrodes arranged in parallel and the concentration of a P-type impurity for threshold control is adjusted to be higher in a source-side portion of an N-type channel region formed under each of the gate electrodes than in a drain-side portion thereof.

To provide a gradient impurity concentration for threshold control in each of the P-type and N-type channel regions, impurity ions to be implanted into the substrate are supplied properly to the substrate surface at a tilt angle of 7° or more from a plane perpendicular to the substrate surface and parallel with the gate width.

Although the present embodiment has described the clocked inverter circuit by way of example, it is not limited thereto. The dynamic logic circuit may also be constituted by using a NAND or NOR circuit in place of the inverter circuit portion.

### (Ninth Embodiment)

A ninth embodiment of the present invention will be described.

The fifth embodiment has used the clocked inverter circuit according to the fourth embodiment to compose each of the clocked inverter circuits 122, 124, 125, and 127 in the data-latch flip-flop circuit shown in FIG. 14.

By contrast, the present embodiment uses the clocked inverter circuit as described above in the eighth embodiment to compose each of the clocked inverter circuits 122, 124, 125, and 127 in the data-latch flip-flop circuit shown in FIG. 14. What results is a data-latch flip-flop circuit having a high driving ability and a low parasitic capacitance during operation at a low voltage.

Although the present embodiment has described the data-latch flip-flop circuit by way of example, it is not limited thereto. A toggle flip-flop circuit or a set-reset flip-flop circuit can also be composed by using an inverter circuit, a multi-input NAND circuit, a multi-input NOR circuit, a clocked inverter circuit, a transmission gate circuit, or a compound logic circuit, as described above. Similar effects can be achieved by applying, to each of the logic circuits composing the foregoing circuits, a novel technique used in the seventh embodiment, which is the technique of laying out a logic circuit composed of a plurality of MOS transistors of one conductivity type having respective gate electrodes placed in parallel such that carriers constantly drift in a specified direction in each of the channel regions with a gradient impurity concentration in which the concentration of an impurity for threshold control gradually decreases as the distance from the source side increases.

## Claims

1. A semiconductor device comprising:
a single semiconductor substrate; and
a plurality of MIS transistors formed on said semiconductor substrate, one of said MIS transistors of a first conductivity type having a source region connected in series to a drain region of another of said MIS transistors of the first conductivity type,
said MIS transistors having
respective gate electrodes placed in parallel with each other on said semiconductor substrate and
respective channel regions formed in said semiconductor substrate to underlie said individual gate electrodes such that carriers drift in the same direction in each of said channel regions,
a concentration of an impurity of a second conductivity type being higher in a portion of each of said channel regions closer to said source region than in a portion of each of said channel regions closer to said drain region.

2. A semiconductor device comprising:
a single semiconductor substrate; and
a NAND circuit formed on said semiconductor substrate, said NAND circuit being composed of two P-channel MOS transistors each having source and drain regions connected in parallel to source and drain regions of the other P-channel MOS transistor, respectively, and of two N-channel MOS transistors each having a source region connected in series to a drain region of the other N-channel MOS transistor,
said two N-channel MOS transistors having
respective gate electrodes placed in parallel with each other on said semiconductor substrate and
respective channel regions formed in said semiconductor substrate to underlie said individual gate electrodes such that carriers drift in the same direction in each of said channel regions,
a concentration of a p-type impurity being higher in a portion of each of said channel regions closer to said source region than in a portion of each of said channel regions closer to said drain region.

3. A semiconductor device comprising:
a single semiconductor substrate; and
a NOR circuit formed on said semiconductor substrate, said NOR circuit being composed of two P-channel MOS transistors each having a source region connected in series to a drain region of the other P-channel MOS transistor and of two N-channel MOS transistors each having source and drain regions connected in parallel to source and drain regions of the other N-channel MOS transistor, respectively,
said two P-channel MOS transistors having
respective gate electrodes placed in parallel with each other on said semiconductor substrate and
respective channel regions formed in said semiconductor substrate to underlie said individual gate electrodes such that carriers drift in the same direction in each of said channel regions,
a concentration of an n-type impurity being higher in a portion of each of said channel regions closer to said source region than in a portion of each of said channel regions closer to said drain region.

4. A semiconductor device comprising:
a single semiconductor substrate; and
a compound logic circuit formed on said semiconductor substrate, said compound logic circuit including a plurality of N-channel MOS transistors, one of said N-channel MOS transistors having a source region connected in series to a drain region of another of said N-channel MOS transistors,
said N-channel MOS transistors having
respective gate electrodes placed in parallel with each other on said semiconductor substrate and
respective channel regions formed in said semiconductor substrate to underlie said individual gate electrodes such that carriers drift in the same direction in each of said channel regions,
a concentration of a P-type impurity being higher in a portion of each of said channel regions closer to said source region than in a portion of each of said channel regions closer to said drain region.

5. A semiconductor device comprising:
a single semiconductor substrate; and
a plurality of MIS transistors formed on said semiconductor substrate, one of said MIS transistors of a first conductivity type having a source region connected in series to a drain region of another of said MIS transistors of the first conductivity type, one of said MIS transistors of a second conductivity type having a source region connected in series to a drain region of another of said MIS transistors of the second conductivity type,
said MIS transistors of the first conductivity type having
respective gate electrodes placed in parallel with each other on said semiconductor substrate and
respective channel regions of the first conductivity type formed in said semiconductor substrate to underlie said individual gate electrodes such that carriers drift in the same direction in each of said channel regions of the first conductivity type,
a concentration of an impurity of the second conductivity type being higher in a portion of each of said channel regions of the first conductivity type closer to said source region than in a portion of each of said channel regions of the first conductivity type closer to said drain region,
said MIS transistors of the second conductivity type having
respective gate electrodes placed in parallel with each other on said semiconductor substrate; and
respective channel regions of the second conductivity type formed in said semiconductor substrate to underlie said individual gate electrodes such that carriers drift in the same direction in each of said channel regions of the second conductivity type,
a concentration of an impurity of the first conductivity type being higher in a portion of each of said channel regions of the second conductivity type closer to said source region than in a portion of each of said channel regions of the second conductivity type closer to said drain region.

6. A semiconductor device according to claim 5, wherein said first conductivity type is a P type, said second conductivity type is an N type, and said MIS transistors are MOS transistors, said semiconductor device comprising:
an inverter circuit composed of a first P-channel MOS transistor and a first N-channel MOS transistor included in said MOS transistors; and
a clocked inverter circuit composed of a second P-channel MOS transistor connected in series between a source electrode of said first P-channel MOS transistor and a power-source voltage terminal to be controlled by a clock signal and a second N-channel MOS transistor connected in series between a source electrode of said first N-channel MOS transistor and a ground voltage terminal to be controlled by a complementary clock signal.

7. A semiconductor device according to claim 6, further comprising a flip-flop circuit including said clocked inverter circuit.

8. A semiconductor device comprising:
a single semiconductor substrate; and
a DRAM circuit formed on said substrate, said DRAM circuit being constituted by a memory cell array unit composed of an array of numerous memory cells for holding data and by a peripheral circuit unit for controlling read/write operations performed with respect to said memory cell array unit,
said peripheral circuit unit having a decoder circuit including
a NAND circuit composed of a plurality of P-channel MOS transistors, one of said P-channel MOS transistors having source and drain regions connected in parallel to source and drain regions of another of said P-channel MOS transistors, respectively, and of a plurality of N-channel MOS transistors, one of said N-channel MOS transistors having a source region connected in series to a drain region of another of said N-channel MOS transistors and
a NOR circuit composed of a plurality of P-channel MOS transistors, one of said P-channel MOS transistors having a source region connected in series to a drain region of another of said P-channel MOS transistors, and of a plurality of N-channel MOS transistors, one of said N-channel MOS transistors having source and drain regions connected in parallel to source and drain regions of another of said N-channel MOS transistors, respectively,
said N-channel MOS transistors composing said NAND circuit having
respective gate electrodes placed in parallel with each other on said semiconductor substrate and
respective N-type channel regions formed in said semiconductor substrate to underlie said individual gate electrodes such that carriers drift in the same direction in each of said N-type channel regions,
a concentration of a P-type impurity being higher in a portion of each of said N-type channel regions closer to said source region than in a portion of each of said N-type channel regions closer to said drain region,
said P-channel MOS transistors composing said NOR circuit having
respective gate electrodes placed in parallel with each other on said semiconductor substrate and
respective P-type channel regions formed in said semiconductor substrate to underlie said individual gate electrodes such that carriers drift in the same direction in each of said P-type channel regions,
a concentration of an N-type impurity being higher in a portion of each of said P-type channel regions closer to said source region than in a portion of each of said P-type channel regions closer to said drain region.

9. A semiconductor device comprising:
a single semiconductor substrate; and
a plurality of MIS transistors of a first conductivity type formed on said semiconductor substrate, said MIS transistors of the first conductivity type having respective gate electrodes placed in parallel with each other and respective source and drain regions formed at both ends of respective lengths of said gate electrodes,
a channel region being formed under the gate electrode of one of said MIS transistors of the first conductivity type such that carriers drift in one direction in said channel region,
a concentration of an impurity of a second conductivity type being higher in a portion of said channel region closer to the source region than in a portion of said channel region closer to the drain region.

10. A semiconductor device according to claim 9, wherein a concentration of the impurity of the second conductivity type is higher in a portion of a channel region of another of said MIS transistors closer to the source region than in a portion thereof closer to the drain region.

11. A semiconductor device comprising:
a single semiconductor substrate; and
a transmission gate circuit formed on said semiconductor substrate, said transmission gate circuit being constituted by an inverter circuit composed of a first P-channel MOS transistor and a first N-channel MOS transistor having respective drain regions connected to each other and by a transfer gate circuit composed of a second P-channel MOS transistor and a second N-channel MOS transistor having respective source regions and respective drain regions connected in parallel to each other to receive an output from said inverter circuit,
said first and second P-channel MOS transistors having respective gate electrodes placed in parallel with each other and said first and second N-channel MOS transistors having respective gate electrodes placed in parallel with each other,
a P-type channel region being formed under said gate electrode of said first P-channel MOS transistor such that carriers drift in one direction in said P-type channel region, a concentration of an N-type impurity being higher in a portion of said P-type channel region closer to a source region than in a portion of said P-type channel region closer to a drain region,
an N-type channel region being formed under said gate electrode of said first N-channel MOS transistor such that carriers drift in one direction in said N-type channel region, a concentration of a P-type impurity being higher in a portion of said N-type channel region closer to a source region than in a portion of said N-type channel region closer to a drain region.

12. A semiconductor device according to claim 11, wherein a concentration of the N-type impurity is higher in a portion of a P-type channel region of said second P-channel MOS transistor closer to the source region than in a portion thereof closer to the drain region and a concentration of the P-type impurity is higher in a portion of an N-type channel region of said second N-channel MOS transistor closer to the source region than in a portion thereof closer to the drain region.

13. A semiconductor device comprising:
a single semiconductor substrate; and
a clocked inverter circuit constituted by
a first inverter circuit composed of a first P-channel MOS transistor and a first N-channel MOS transistor connected to each other, said first inverter generating a complementary clock signal by inverting a clock signal inputted thereto,
a second inverter circuit composed of a second P-channel MOS transistor and a second N-channel MOS transistor connected to each other, said second inverter circuit outputting an inverted signal obtained by inverting an input signal, and
a transfer gate circuit composed of a third P-channel MOS transistor and a third N-channel MOS transistor connected in parallel to each other, said transfer gate circuit outputting said inverted signal under the control of said clock signal and said complementary clock signal,
said first and second P-channel MOS transistors having respective gate electrodes placed in parallel with each other and said first and second N-channel MOS transistors having respective gate electrodes placed in parallel with each other,
a P-type channel region being formed under said gate electrode of said first P-channel MOS transistor such that carriers drift in one direction in said P-type channel region, a concentration of an N-type impurity being higher in a portion of said P-type channel region closer to a source region than in a portion of said P-type channel region closer to a drain region,
an N-type channel region being formed under said gate electrode of said first N-channel MOS transistor such that carriers drift in one direction in said N-type channel region, a concentration of a P-type impurity being higher in a portion of said N-type channel region closer to a source region than in a portion of said N-type channel region closer to a drain region.

14. A semiconductor device according to claim 13, wherein a concentration of the N-type impurity is higher in a portion of a P-type channel region of said second P-channel MOS transistor closer to the source region than in a portion thereof closer to the drain region and a concentration of the P-type impurity is higher in a portion of an N-type channel region of said second N-channel MOS transistor closer to the source region than in a portion thereof closer to the drain region.

15. A semiconductor device according to claim 13, further comprising a flip-flop circuit including said clocked inverter circuit.

16. A method of manufacturing a semiconductor device, comprising the steps of:
sequentially depositing a gate insulating film and a conductive film over an entire surface of a semiconductor substrate of a first conductivity type;
selectively etching said conductive film and said gate insulating film to expose a top surface of said semiconductor substrate and thereby forming a plurality of gate electrodes in parallel with each other on said semiconductor substrate, said gate electrodes being composed of said conductive film deposited on said semiconductor substrate with said gate insulating film interposed therebetween;
implanting ions of an impurity of the first conductivity type into said semiconductor substrate by using said gate electrodes as a mask, said ions being supplied to a substrate surface at a tilt angle of 7° or more from a plane perpendicular to the substrate surface and parallel with a gate width toward one end of a gate length to form impurity diffusion layers for threshold control in respective regions of said semiconductor substrate underlying said gate electrodes such that a concentration of the impurity of the first conductivity type gradually decreases as a distance from one end of the gate length increases in each of the impurity diffusion layers; and
implanting ions of an impurity of a second conductivity type into said semiconductor substrate by using said gate electrodes as a mask to form source and drain regions at both ends of the gate length in said semiconductor substrate.
